# EUROPEAN PATENT APPLICATION

(11) **EP 4 819 785 A1**
(43) Date of publication of application: **07.10.2026**
(21) Application number: 25223800.1
(22) Date of filing: 16.12.2025
(51) Int. Cl.: H10B 12/00

(54) **SEMICONDUCTOR DEVICE AND METHOD FOR MANUFACTURING THE SAME**

(30) Priority: 04.04.2025 KR 20250044342
(71) Applicant: SK hynix Inc., Bubal-eub Icheon-si Gyeonggi-do 17336 (KR)
(72) Inventor: NAM, Yoon Jae, 17336 Icheon-si, Gyeonggi-do (KR)
(74) Representative: Isarpatent

(57) **Abstract**

The semiconductor device includes: a plurality of word-lines extending in a first direction, a plurality of active regions extending in a diagonal direction with the first direction, the plurality of the active regions configured to overlap with the word-line structures, a plurality of bit-line pad regions each of which overlaps with one end of the active region, a plurality of storage-node pad regions each of which overlaps with another end of the active region, a plurality of first pad insulation regions each of which contacts the bit-line pad region, contacts the one side of the word-line structure and having a first height, and a plurality of second pad insulation regions each of which contacts the storage-node pad region contacts the another side of the word-line structure, having a second height higher than the first height.

## Description

### TECHNICAL FIELD

The technology and embodiments of the present disclosure generally relate to a semiconductor device and a method for manufacturing the same, and more particularly to a semiconductor device including a plurality of active regions.

### BACKGROUND

A semiconductor device having a memory function among various semiconductor devices is a device that can be used to store information, and may include an array having individual memory cells including transistors. Semiconductor devices having a memory function may include, for example, a dynamic random access memory (DRAM). A DRAM may include bit lines and word lines that may cross each other in a vertical direction. The bit lines and word lines may extend across an array including the memory cells. The bit lines and word lines may be used to access individual memory cells.

Memory performance, cell stability and reliability, power efficiency, ease of processing, cost, and the like may vary depending on how individual memory cells are designed and placed, and thus research on a cell array design of a memory device and a fabrication process of the cell array is being actively conducted.

### SUMMARY

Various embodiments of the present disclosure relate to a semiconductor device capable of solving existing issues in which a bridge phenomenon occurs in adjacent active regions and reliability of the semiconductor device deteriorates when word lines are misaligned in a fabrication process of the semiconductor device.

Various embodiments of the present disclosure relate to a semiconductor device capable of solving existing issues in which contact resistance increases as a contact area where a bit-line contact or a storage-node contact overlap with the active regions decreases in size.

In accordance with an embodiment of the present disclosure, a semiconductor device may include a plurality of word-line structures extending in a first direction, and configured spaced apart from each other in a second direction; a plurality of active regions extending in a diagonal direction forming an acute angle with the first direction, configured to overlap with the word-line structures, and configured spaced apart from each other in the first direction; a plurality of bit-line pad regions, each of which overlaps with one end of the active region and contacts one side of the word-line structure; a plurality of storage-node pad regions, each of which overlaps with another end of the active region and contacts another side of the word-line structure; a plurality of first pad insulation regions, each of which contacts the bit-line pad region, contacts the one side of the word-line structure, and is formed to have a first height; and a plurality of second pad insulation regions, each of which contacts the storage-node pad region, contacts the another side of the word-line structure, and is formed to have a second height higher than the first height.

In an embodiment, each of the plurality of the bit-line pad regions may have a third height from a top surface of the active region; each of the plurality of the storage-node pad regions may have a fourth height from the top surface of the active region; and each of the third height and the fourth height may be equal to the second height.

In an embodiment, a bottom surface of the bit-line pad region and a bottom surface of the storage-node pad region may be located lower than a bottom surface of the first pad insulation region.

In an embodiment, a bottom surface of the bit-line pad region and a bottom surface of the storage-node pad region may be located at the same plane as a bottom surface of the second pad insulation region.

In an embodiment, the semiconductor device may further include a plurality of bit-line contact regions, each of which contacts a top surface of the bit-line pad region; and a plurality of storage-node contact regions, each of which contacts a top surface of the storage-node pad region.

In an embodiment, the semiconductor device may further include a plurality of bit-line electrode layers, each of which is disposed on the bit-line contact region, overlaps with the bit-line pad region, and extends in the second direction; and a plurality of bit-line spacers, each of which contacts both sides of the bit-line electrode layer and extends in the second direction.

In an embodiment, the second direction may be perpendicular to the first direction; and the second direction may form an acute angle with the diagonal direction.

In an embodiment, an angle formed between the diagonal direction and the first direction may be in a range of 30 degrees to 60 degrees.

In an embodiment, the plurality of the active regions may be further arranged spaced apart from each other in the second direction; and the plurality of the active regions may be further arranged spaced apart from each other in the diagonal direction.

In an embodiment, each of the plurality of the bit-line pad regions may be arranged spaced apart from each other in the second direction; and each of the plurality of the storage-node pad regions may be arranged spaced apart from each other in the second direction.

In an embodiment, each of the plurality of the first pad insulation regions may contact a side surface of the bit-line pad region facing the first direction, and each of the plurality of the first pad insulation regions may contact a side surface of the storage-node pad region facing an opposite direction to the first direction. Each of the plurality of the second pad insulation regions may contact a side surface of the bit-line pad region facing the opposite direction to the first direction, and each of the plurality of the second pad insulation regions may contact a side surface of the storage-node pad region facing the first direction.

In an embodiment, the plurality of the first pad insulation regions may be arranged spaced apart from each other in the second direction; and the plurality of the second pad insulation regions may be arranged spaced apart from each other in the second direction.

In an embodiment, the semiconductor device may further include a cell isolation region configured to surround the plurality of the active regions, wherein each of the plurality of the first pad insulation regions contacts a top surface of the cell isolation region.

In an embodiment, each of the plurality of the bit-line pad regions and each of the plurality of the storage-node pad regions may include polysilicon.

In accordance with another embodiment of the present disclosure, a method for manufacturing a semiconductor device may include forming a plurality of active regions that is arranged repeatedly spaced apart from each other in a first direction and a second direction, extends in a diagonal direction with respect to the first direction, and is surrounded by a cell isolation region; forming a first insulation layer over the plurality of the active regions and the cell isolation region; forming a plurality of open trenches, each of which is formed by etching a portion of two adjacent active regions and a portion of the first insulation layer; forming a pad layer that covers not only a plurality of first pad insulation regions remaining after the first insulation layer is etched, but also the plurality of the open trenches; removing a portion formed at a central portion of each of the open trenches among the pad layer; and forming a second pad insulation region at the central portion of the open trench.

In an embodiment, the method for manufacturing the semiconductor device may further include forming a plurality of word-line structures, each of which overlaps with the plurality of the active regions, extends in the first direction, and is repeatedly spaced apart from each other in the second direction.

In an embodiment, forming the plurality of the word-line structures may include: forming a word-line trench. The word-line trench is configured to cut the plurality of the pad layers that extends in the second direction and is spaced apart from each other in the first direction to form a plurality of bit-line pad regions and a plurality of storage-node pad regions; and cut the plurality of the first pad insulation regions each extending in the second direction and the plurality of the second pad insulation regions each extending in the second direction, whereby the word-line trench is recessed into the plurality of the active regions.

In an embodiment, the plurality of the bit-line pad regions may be configured to overlap one end of each of the plurality of the active regions; and the plurality of the storage-node pad regions may be configured to overlap another end of each of the plurality of the active regions.

In an embodiment, forming the plurality of the word-line structures may further include forming a word-line electrode layer to which an operation signal of the word-line structure is applied; forming a word-line insulation layer that is formed along an inner wall of the word-line trench and surrounds a bottom surface and side surfaces of the word-line electrode layer; and forming a word-line capping layer contacting a top surface of the word-line electrode layer.

In an embodiment, the method for manufacturing the semiconductor device may further include forming a plurality of bit-line contact regions that is respectively disposed on the bit-line pad regions, extends in the second direction, and is spaced apart from each other in the first direction; forming a plurality of bit-line electrode layers that is respectively disposed on the bit-line contact regions, extends in the second direction, and is spaced apart from each other in the first direction; forming a plurality of bit-line spacers, each of which contacts both sides of each of the bit-line electrode layers and extends in the second direction; and forming a plurality of storage-node contact regions, each of which is disposed on the storage-node pad region.

It is to be understood that both the foregoing general description and the following detailed description of the present disclosure are illustrative and descriptive and are intended to provide further description of the embodiments of the present disclosure as claimed.

### BRIEF DESCRIPTION OF THE DRAWINGS

The above and other features and beneficial aspects of the present disclosure will become readily apparent to those with ordinary skill in the art from the following detailed description when considered in conjunction with the accompanying drawings.
FIG. 1 is a circuit diagram illustrating a modeling circuit of a unit cell of a semiconductor device based on an embodiment of the present disclosure.
FIG. 2 is a first plan view illustrating a portion of a semiconductor device based on an embodiment of the present disclosure.
FIG. 3 is a second plan view illustrating a portion of a semiconductor device based on an embodiment of the present disclosure.
FIG. 4 is a cross-sectional view illustrating a structure of the semiconductor device taken along the line A-A' of FIGS. 2 and 3 based on an embodiment of the present disclosure.
FIG. 5 is a cross-sectional view illustrating a structure of the semiconductor device taken along the line B-B' of FIGS. 2 and 3 based on an embodiment of the present disclosure.
FIG. 6 is a cross-sectional view illustrating a structure of the semiconductor device taken along the line C-C' of FIGS. 2 and 3 based on an embodiment of the present disclosure.
FIG. 7 is a cross-sectional view illustrating a structure of the semiconductor device taken along the line D-D' of FIGS. 2 and 3 based on an embodiment of the present disclosure.
FIG. 8 is a cross-sectional view illustrating a structure of the semiconductor device taken along the line E-E' of FIGS. 2 and 3 based on an embodiment of the present disclosure.
FIG. 9 is a flowchart illustrating a method for manufacturing a semiconductor device based on an embodiment of the present disclosure.
FIG. 10A is a plan view illustrating a result of performing operation S10 of FIG. 9 based on an embodiment of the present disclosure.
FIG. 10B is a cross-sectional view illustrating an example structure of the semiconductor device taken along the line A-A' of FIG. 10A based on an embodiment of the present disclosure.
FIG. 10C is a cross-sectional view illustrating a structure of the semiconductor device taken along the line B-B' of FIG. 10A based on an embodiment of the present disclosure.
FIG. 10D is a cross-sectional view illustrating a structure of the semiconductor device taken along the line C-C' of FIG. 10A based on an embodiment of the present disclosure.
FIG. 10E is a cross-sectional view illustrating a structure of the semiconductor device taken along the line D-D' of FIG. 10A based on an embodiment of the present disclosure.
FIG. 10F is a cross-sectional view illustrating a structure of the semiconductor device taken along the line E-E' of FIG. 10A based on an embodiment of the present disclosure.
FIG. 11A is a plan view illustrating a result of performing operation S20 of FIG. 9 based on an embodiment of the present disclosure.
FIG. 11B is a cross-sectional view illustrating a structure of the semiconductor device taken along the line A-A' of FIG. 11A based on an embodiment of the present disclosure.
FIG. 11C is a cross-sectional view illustrating a structure of the semiconductor device taken along the line B-B' of FIG. 11A based on an embodiment of the present disclosure.
FIG. 11D is a cross-sectional view illustrating a structure of the semiconductor device taken along the line C-C' of FIG. 11A based on an embodiment of the present disclosure.
FIG. 11E is a cross-sectional view illustrating a structure of the semiconductor device taken along the line D-D' of FIG. 11A based on an embodiment of the present disclosure.
FIG. 11F is a cross-sectional view illustrating a structure of the semiconductor device taken along the line E-E' of FIG. 11A based on an embodiment of the present disclosure.
FIG. 12A is a plan view illustrating a result of performing operation S30 of FIG. 9 based on an embodiment of the present disclosure.
FIG. 12B is a cross-sectional view illustrating a structure of the semiconductor device taken along the line A-A' of FIG. 12A based on an embodiment of the present disclosure.
FIG. 12C is a cross-sectional view illustrating a structure of the semiconductor device taken along the line B-B' of FIG. 12A based on an embodiment of the present disclosure.
FIG. 12D is a cross-sectional view illustrating a structure of the semiconductor device taken along the line C-C' of FIG. 12A based on an embodiment of the present disclosure.
FIG. 12E is a cross-sectional view illustrating a structure of the semiconductor device taken along the line D-D' of FIG. 12A based on an embodiment of the present disclosure.
FIG. 12F is a cross-sectional view illustrating a structure of the semiconductor device taken along the line E-E' of FIG. 12A based on an embodiment of the present disclosure.
FIG. 13A is a plan view illustrating a result of performing operation S40 of FIG. 9 based on an embodiment of the present disclosure.
FIG. 13B is a cross-sectional view illustrating a structure of the semiconductor device taken along the line A-A' of FIG. 13A based on an embodiment of the present disclosure.
FIG. 13C is a cross-sectional view illustrating a structure of the semiconductor device taken along the line B-B' of FIG. 13A based on an embodiment of the present disclosure.
FIG. 13D is a cross-sectional view illustrating a structure of the semiconductor device taken along the line C-C' of FIG. 13A based on an embodiment of the present disclosure.
FIG. 13E is a cross-sectional view illustrating a structure of the semiconductor device taken along the line D-D' of FIG. 13A based on an embodiment of the present disclosure.
FIG. 13F is a cross-sectional view illustrating a structure of the semiconductor device taken along the line E-E' of FIG. 13A based on an embodiment of the present disclosure.
FIG. 14A is a plan view illustrating a result of performing operation S50 of FIG. 9 based on an embodiment of the present disclosure.
FIG. 14B is a cross-sectional view illustrating a structure of the semiconductor device taken along the line A-A' of FIG. 14A based on an embodiment of the present disclosure.
FIG. 14C is a cross-sectional view illustrating a structure of the semiconductor device taken along the line B-B' of FIG. 14A based on an embodiment of the present disclosure.
FIG. 14D is a cross-sectional view illustrating a structure of the semiconductor device taken along the line C-C' of FIG. 14A based on an embodiment of the present disclosure.
FIG. 14E is a cross-sectional view illustrating a structure of the semiconductor device taken along the line D-D' of FIG. 14A based on an embodiment of the present disclosure.
FIG. 14F is a cross-sectional view illustrating a structure of the semiconductor device taken along the line E-E' of FIG. 14A based on an embodiment of the present disclosure.
FIG. 15A is a plan view illustrating a result of performing operation S60 of FIG. 9 based on an embodiment of the present disclosure.
FIG. 15B is a cross-sectional view illustrating a structure of the semiconductor device taken along the line A-A' of FIG. 15A based on an embodiment of the present disclosure.
FIG. 15C is a cross-sectional view illustrating a structure of the semiconductor device taken along the line B-B' of FIG. 15A based on an embodiment of the present disclosure.
FIG. 15D is a cross-sectional view illustrating a structure of the semiconductor device taken along the line C-C' of FIG. 15A based on an embodiment of the present disclosure.
FIG. 15E is a cross-sectional view illustrating a structure of the semiconductor device taken along the line D-D' of FIG. 15A based on an embodiment of the present disclosure.
FIG. 15F is a cross-sectional view illustrating a structure of the semiconductor device taken along the line E-E' of FIG. 15A based on an embodiment of the present disclosure.
FIG. 16A is a plan view illustrating a result of performing operation S70 of FIG. 9 based on an embodiment of the present disclosure.
FIG. 16B is a cross-sectional view illustrating a structure of the semiconductor device taken along the line A-A' of FIG. 16A based on an embodiment of the present disclosure.
FIG. 16C is a cross-sectional view illustrating a structure of the semiconductor device taken along the line B-B' of FIG. 16A based on an embodiment of the present disclosure.
FIG. 16D is a cross-sectional view illustrating a structure of the semiconductor device taken along the line C-C' of FIG. 16A based on an embodiment of the present disclosure.
FIG. 16E is a cross-sectional view illustrating a structure of the semiconductor device taken along the line D-D' of FIG. 16A based on an embodiment of the present disclosure.
FIG. 16F is a cross-sectional view illustrating a structure of the semiconductor device taken along the line E-E' of FIG. 16A based on an embodiment of the present disclosure.
FIG. 17A is a plan view illustrating a result of performing operation S80 of FIG. 9 based on an embodiment of the present disclosure.
FIG. 17B is a cross-sectional view illustrating a structure of the semiconductor device taken along the line A-A' of FIG. 17A based on an embodiment of the present disclosure.
FIG. 17C is a cross-sectional view illustrating a structure of the semiconductor device taken along the line B-B' of FIG. 17A based on an embodiment of the present disclosure.
FIG. 17D is a cross-sectional view illustrating a structure of the semiconductor device taken along the line C-C' of FIG. 17A based on an embodiment of the present disclosure.
FIG. 17E is a cross-sectional view illustrating a structure of the semiconductor device taken along the line D-D' of FIG. 17A based on an embodiment of the present disclosure.
FIG. 17F is a cross-sectional view illustrating a structure of the semiconductor device taken along the line E-E' of FIG. 17A based on an embodiment of the present disclosure.
FIG. 18A is a plan view illustrating a result of performing operation S90 of FIG. 9 based on an embodiment of the present disclosure.
FIG. 18B is a cross-sectional view illustrating a structure of the semiconductor device taken along the line A-A' of FIG. 18A based on an embodiment of the present disclosure.
FIG. 18C is a cross-sectional view illustrating a structure of the semiconductor device taken along the line B-B' of FIG. 18A based on an embodiment of the present disclosure.
FIG. 18D is a cross-sectional view illustrating a structure of the semiconductor device taken along the line C-C' of FIG. 18A based on an embodiment of the present disclosure.
FIG. 18E is a cross-sectional view illustrating a structure of the semiconductor device taken along the line D-D' of FIG. 18A based on an embodiment of the present disclosure.
FIG. 18F is a cross-sectional view illustrating a structure of the semiconductor device taken along the line E-E' of FIG. 18A based on an embodiment of the present disclosure.
FIG. 19 is a plan view illustrating a portion of a semiconductor device when the word-line structure or the bit-line structure shown in FIG. 3 is misaligned.

### DETAILED DESCRIPTION

The present disclosure provides embodiments of a semiconductor device including a plurality of active regions and a method for manufacturing the same that may be used in configurations to substantially address one or more technical or engineering issues and to mitigate limitations or disadvantages encountered in some semiconductor devices in the art. An embodiment of the present disclosure relates to a semiconductor device capable of solving the existing problems in which a bridge phenomenon occurs in adjacent active regions and reliability of the semiconductor device deteriorates when word lines are misaligned in a fabrication process of the semiconductor device. An embodiment of the present disclosure relates to a semiconductor device capable of solving the existing problems in which contact resistance increases as a contact area where a bit-line contact or a storage-node contact overlap with the active regions decreases in size. In recognition of the issues above, the semiconductor device based on an embodiment of the present disclosure can advantageously facilitate a fabrication process of bit-line contacts and storage-node contacts, thereby securing necessary resistance. The semiconductor device includes a pad region disposed between the bit-line contact and the active region and another pad region disposed between the storage-node contact and the active region, resulting in reduction in contact resistance. The semiconductor device is configured such that a predetermined pad region and pad insulation regions are formed to be higher than a surface of the active region so that a cell isolation region can have a smaller depth, thereby reducing fabrication difficulty in a patterning process of the active regions. The semiconductor device and the method for manufacturing the same can reduce production costs of the semiconductor device, and can simplify the fabrication process (i.e., can reduce the number of fabrication steps) of the semiconductor device.

Reference will now be made in detail to the embodiments of the present disclosure which are illustrated in the accompanying drawings. Wherever possible, the same reference numbers will be used throughout the drawings to refer to the same or like parts. While the embodiments of the present disclosure are susceptible to various modifications and alternative forms, specific embodiments thereof are shown in the drawings. However, the embodiments should not be construed as being limited to the embodiments set forth herein.

Hereinafter, various embodiments will be described with reference to the accompanying drawings. However, it should be understood that the embodiments are not limited to specific embodiments, but include various modifications, equivalents and/or alternatives of the embodiments. The embodiments of the present disclosure may provide a variety of advantageous effects capable of being directly or indirectly recognized by one of ordinary skill in the art.

In describing the components of the embodiments of the present disclosure, various terms such as first, second, etc., may be used solely for the purpose of differentiating one component from another, but the essence, order and sequence of the components are not limited to these terms. Unless defined otherwise, all terms, including technical and scientific terms, used in the present disclosure may have the same meaning as commonly understood by a person having ordinary skill in the art to which the present disclosure pertains. It will be further understood that terms, such as those defined in commonly used dictionaries, may be interpreted as having a meaning that is consistent with their meaning in the context of the related art and the present disclosure, and should not be interpreted in an idealized or overly formal sense unless expressly so defined herein.

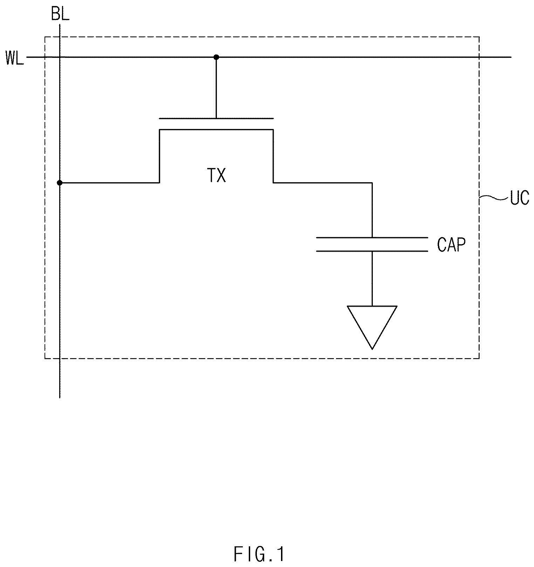

FIG. 1 is a circuit diagram illustrating a modeling circuit of a unit cell (UC) of a semiconductor device based on an embodiment of the present disclosure.

Referring to FIG. 1, the unit cell (UC) of the semiconductor device according to an embodiment of the present disclosure may include a transistor (TX) and a capacitor (CAP). The unit cell (UC) may be a unit that stores data in the semiconductor device. The semiconductor device according to an embodiment of the present disclosure may function as a data storage device that may be included in various electronic devices such as computers. In an embodiment, the semiconductor device may be a volatile memory device (e.g., a dynamic random access memory (DRAM)) or a non-volatile memory device (e.g., a NAND memory).

The transistor (TX) may be a switching element between a bit line (BL) and a capacitor (CAP). The transistor (TX) may be, for example, a metal oxide semiconductor field effect transistor (MOSFET). The transistor (TX) may operate with an electric field generated by a voltage applied to a gate terminal thereof. When the transistor (TX) is turned on, the bit line (BL) and the capacitor (CAP) may be electrically connected to each other. When the transistor (TX) is turned off, electrical connection between the bit line (BL) and the capacitor (CAP) may be prevented.

The word line (WL) may adjust (control) on/off states of the transistor (TX). For example, when a word-line signal applied to the word line (WL) has a logic high level, the transistor (TX) may be turned on. On the other hand, when the word-line signal applied to the word line (WL) has a logic low level, the transistor (TX) may be turned off.

The bit line (BL) may be an interconnect structure designed to transmit data. The bit line (BL) may transfer charges to the capacitor (CAP) when the transistor (TX) is turned on. When the bit-line signal applied to the bit line (BL) has a high level and the transistor (TX) is turned on, data "1" may be stored in the capacitor (CAP). When the bit-line signal applied to the bit line (BL) has a low level and the transistor (TX) is turned on, data "0" may be stored in the capacitor (CAP). The bit line (BL) functions as a data conduit that stores either a "1" or "0" in the capacitor (CAP) based on the signal level when the transistor is activated.

A capacitor (CAP) may be a storage device that stores data. For example, the second capacitor (CAP) may include at least one of a Metal-Insulator-Metal (MIM) capacitor, a Metal-Oxide-Metal (MOM) capacitor, or a Metal-Oxide-Semiconductor (MOS) capacitor, without being limited thereto. When the capacitor (CAP) stores charges of a predetermined level or higher, the unit cell (UC) may be in a state of storing data "1". When the capacitor (CAP) stores charges of a predetermined level or less, the unit cell (UC) may be in a state of storing data "0".

In an operation of writing data "1" to the unit cell (UC), a bit-line signal of a high level may be applied to the bit line (BL), and a word-line signal of a high level may be applied to the word line (WL). When the transistor (TX) is turned on by the high-level word-line signal, the bit line (BL) may serve as a drain terminal of the transistor (TX), the capacitor (CAP) may serve as a source terminal of the transistor (TX), and a potential level of the capacitor (CAP) may increase by the high-level bit-line signal, so that data "1" can be written to the unit cell (UC).

In an operation of writing data "0" to the unit cell (UC), a bit-line signal of a low level may be applied to the bit line (BL), and a word-line signal of a high level may be applied to the word line (WL). When the transistor (TX) is turned on, the bit line (BL) may serve as a source terminal of the transistor (TX), and the capacitor (CAP) may serve as drain terminal, and a potential level of the capacitor (CAP) may decrease by the low-level bit-line signal, so that data "0" can be written to the unit cell (UC).

In an operation of reading data of the unit cell (UC), the bit-line signal may have a reference level located between the high level and the low level, and the word-line signal may have a high level. When data "1" is written (stored) to the unit cell (UC) and the transistor (TX) is turned on, the potential level of the capacitor (CAP) is at a high level, so that the level of the bit-line signal may become higher than the reference level. When data "0" is recorded in the unit cell (UC) and the transistor (TX) is turned on, the potential level of the capacitor (CAP) is at a low level, so that the level of the bit-line signal may become lower than the reference level. The semiconductor device may determine whether the level of the bit-line signal becomes higher than the reference level, and may read data of the unit cell (UC) based on the result of determination.

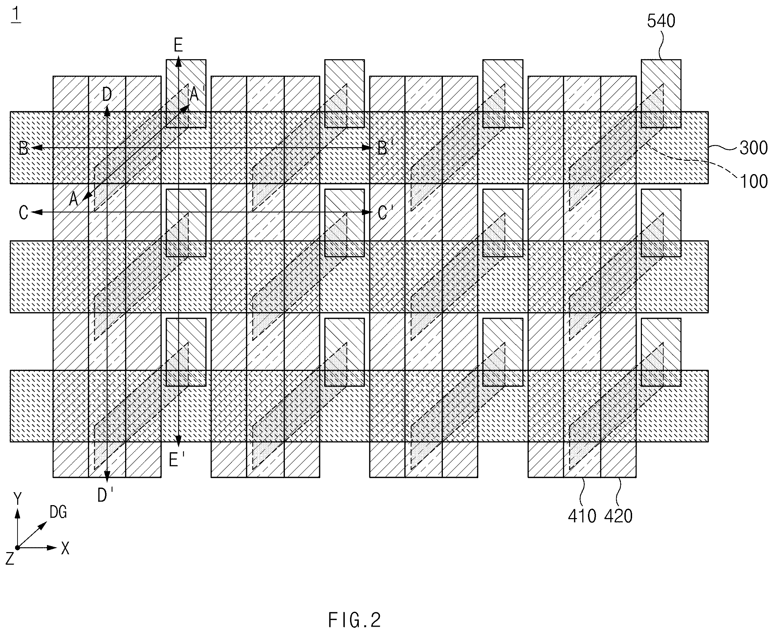

FIG. 2 is a first plan view illustrating a portion of a semiconductor device 1 based on an embodiment of the present disclosure.

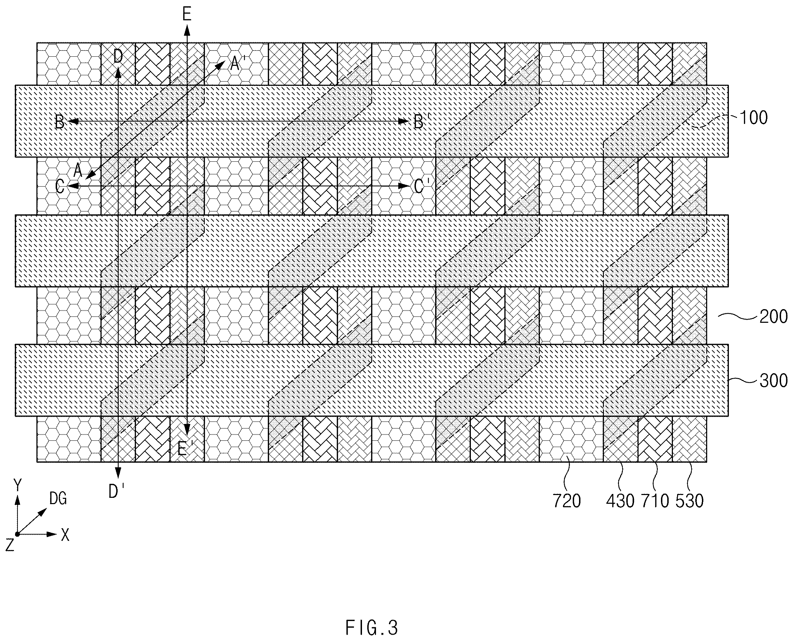

FIG. 3 is a second plan view illustrating a portion of the semiconductor device 1 based on an embodiment of the present disclosure.

Referring to FIGS. 1, 2, and 3, the first plan view and the second plan view are plan views showing the positional relationship between a plurality of active regions 100 and peripheral structures. The first plan view is a plan view showing the positional relationship between the plurality of the active regions 100, the plurality of the word-line structures 300, and peripheral structures arranged on a surface of a predetermined semiconductor layer. The second plan view is a plan view showing the positional relationship between the plurality of the active regions 100 and peripheral structures arranged below the surface of the predetermined semiconductor layer.

The semiconductor device 1 may include a plurality of active regions 100, a cell isolation region 200, a plurality of word-line structures 300, a plurality of bit-line electrode layers 410, a plurality of bit-line spacers 420, a plurality of bit-line pad regions 430, a plurality of storage-node pad regions 530, a plurality of storage-node contact regions 540, a plurality of first pad insulation regions 710, and a plurality of second pad insulation regions 720.

Each of the plurality of the active regions 100 may include a semiconductor material (e.g., silicon (Si), silicon carbide (SiC), etc.). Each of the plurality of the active regions 100 may be surrounded by a cell isolation region 200. For example, the plurality of the active regions 100 may be arranged in a matrix structure. The plurality of the active regions 100 may be arranged in an (m × n) matrix structure, where 'm' is an integer greater than or equal to 2, and 'n' is an integer greater than or equal to 2. Each of the plurality of the active regions 100 may extend in a diagonal direction (DG). The diagonal direction (DG) may be a diagonal direction with respect to a first direction (X). An angle between the diagonal direction (DG) and the first direction (X) may be an acute angle. Some of the plurality of the active regions 100 may be repeatedly arranged spaced apart from each other in the first direction (X). Some of the plurality of the active regions 100 may be repeatedly arranged spaced apart from each other in a second direction (Y) perpendicular to the first direction (X). Some of the plurality of the active regions 100 may be repeatedly arranged spaced apart from each other in a diagonal direction (DG). An angle between the diagonal direction (DG) and the second direction (Y) may be an acute angle. An acute angle between the first direction (X) and the diagonal direction (DG) may be in a range of about 30 degrees to about 60 degrees. Each of the plurality of the active regions 100 may overlap with the word-line structure 300. Although each of the active regions 100 is illustrated in a shape like a parallelogram, the embodiments are not limited thereto. For example, each of the four corner regions of the active region 100 may have a round shape. Each of the plurality of the active regions 100 may include a region in which a channel of a transistor (TX) of a unit cell (UC) is formed. Each of the plurality of the active regions 100 may be surrounded by the cell isolation region 200. One end of each of the plurality of the active regions 100 may overlap with the bit-line electrode layer 410. One end of each of the plurality of the active regions 100 may overlap with a bit-line pad region 430. The other end of each of the plurality of the active regions 100 may overlap with a storage-node contact region 540. The other end of each of the plurality of the active regions 100 may overlap a storage-node pad region 530.

The cell isolation region 200 may include an insulation material. For example, the cell isolation region 200 may include at least one of silicon oxide or a Silicon-On-Insulator (SOI) structure. The cell isolation region 200 may surround each of the plurality of the active regions 100. The cell isolation region 200 may provide electrical insulation between the plurality of the active regions 100 spaced apart from each other.

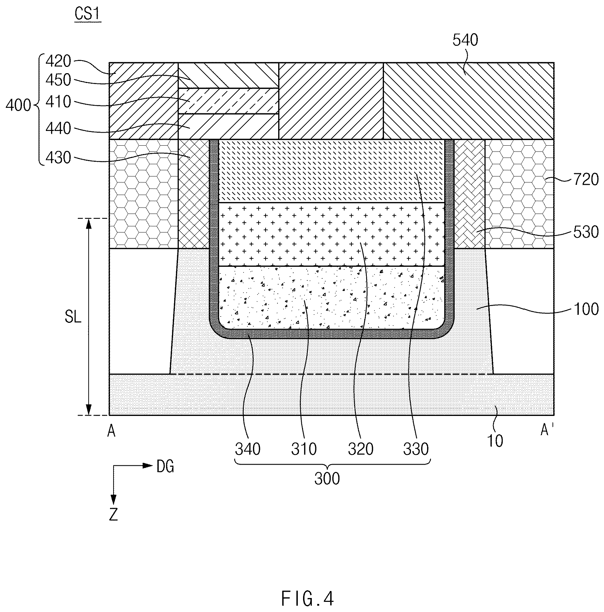

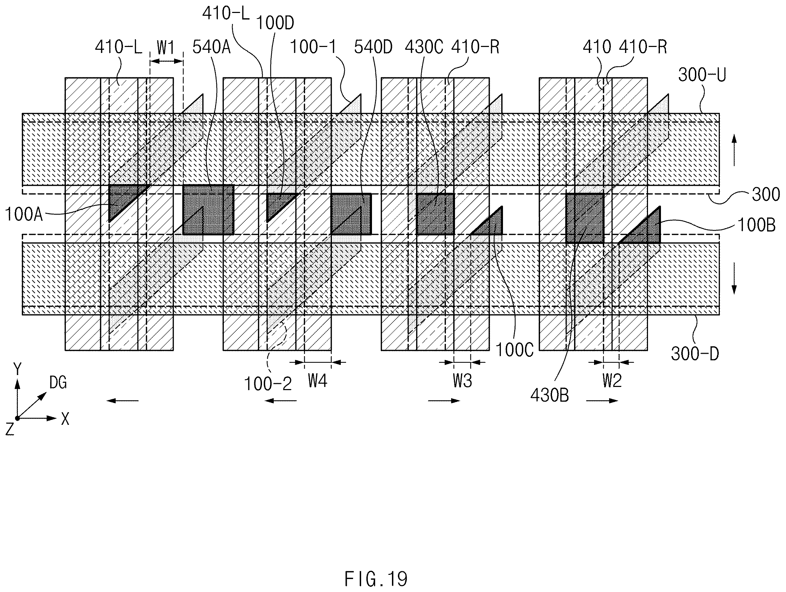

Each of the plurality of the word-line structures 300 may extend in the first direction (X). Each of the plurality of the word-line structures 300 may be arranged spaced apart from each other in the second direction (Y). Each of the plurality of the word-line structures 300 may include a predetermined electrode layer to which a word-line signal is applied. When the word-line signal has a high level in an electrode layer included in the word-line structure 300, a predetermined channel may be formed within the active region 100 overlapping the word-line structure 300. Each of the plurality of the word-line structures 300 may overlap each of the plurality of the active regions 100 spaced apart from each other in the first direction (X). Although each of the plurality of the word-line structures 300 may be formed to pass through the center of each of the plurality of the active regions 100 spaced apart from each other in the first direction (X), other embodiments are also possible, and the structure of the plurality of the word-line structures 300 may vary depending on fabrication limitations and variables. Other embodiments are also possible, and the design and configuration of the word-line structures 300 may vary depending on fabrication limitations and variables in a fabrication process. When misalignment occurs in a masking pattern for forming the word-line structures 300, each of the word-line structures 300 may be formed to be biased (offset) to one side from the center of each of the active regions 100. In this case, a problem of reduced reliability of the semiconductor device 1 may occur due to occurrence of a bridge, but the semiconductor device 1 according to an embodiment of the present disclosure can solve the above problem of reduced reliability and as such detailed description thereof will be described with reference to FIG. 19. As the center of each word-line structure 300 extends in the first direction (X) closer to the center of the active region 100, the reliability of the semiconductor device 1 can be improved. The internal structure of the word-line structures 300 will be described with reference to FIG. 4 and below.

Each of the plurality of the bit-line electrode layers 410 may include a conductive material. For example, each of the plurality of the bit-line electrode layers 410 may include a metal material such as aluminum (Al), copper (Cu), or tungsten (W). Each of the plurality of the bit-line electrode layers 410 may extend in the second direction (Y). Each of the plurality of the bit-line electrode layers 410 may be arranged spaced apart from each other in the first direction (X). The first direction (X) and the second direction (Y) may be perpendicular to each other. Each of the plurality of the bit-line electrode layers 410 may be an electrode layer to which the bit-line signal is applied. Each of the plurality of the bit-line electrode layers 410 may overlap with the plurality of the bit-line pad regions 430 which are spaced apart from each other in the second direction (Y). Each of the plurality of the bit-line electrode layers 410 may intersect (cross) the plurality of the word-line structures 300. Both side surfaces of each of the plurality of the bit-line electrode layers 410 may contact the bit-line spacer 420. Each of the plurality of the bit-line electrode layers 410 may overlap with one end of each active region 100.

Each of the plurality of the bit-line spacers 420 may include an insulation material. For example, each of the plurality of the bit-line spacers 420 may include an insulation material such as silicon oxide or silicon nitride. Each of the plurality of the bit-line spacers 420 may extend in the second direction (Y). The plurality of the bit-line spacers 420 may be arranged spaced apart from each other in the first direction (X). The plurality of the bit-line spacers 420 may prevent electrical interaction between the bit-line electrode layers 410 which are spaced apart from each other. The plurality of the bit-line spacers 420 may form one pair, and one pair of the bit-line spacers 420 may contact both side surfaces of the bit-line electrode layer 410.

Each of the plurality of the bit-line pad regions 430 may include a conductive material. For example, each of the plurality of the bit-line pad regions 430 may include polysilicon. For example, the polysilicon may include at least one predetermined impurity for improving conductivity. Each of the plurality of the bit-line pad regions 430 may be configured to properly transmit a bit-line signal applied to the bit-line electrode layer 410 to the active region 100. Each of the plurality of the bit-line pad regions 430 may be arranged between two adjacent word-line structures 300. For example, each of the plurality of the bit-line pad regions 430 may contact both side surfaces of the two adjacent word-line structures 300 facing each other. The bit-line pad region 430 may overlap with one end of the active region 100. In an arbitrary active region 100, the bit-line pad region 430 may contact one side of the word-line structure 300 overlapping with the active region 100. The bit-line pad region 430 may also contact a word-line structure 300 overlapping with the active region 100 that is spaced apart from the active region 100 in a direction opposite to the second direction (Y). Some of the plurality of the bit-line pad regions 430 may be arranged spaced apart from each other in the first direction (X). Some others of the plurality of the bit-line pad regions 430 may be arranged spaced apart from each other in the second direction (Y).

Each of the plurality of the storage-node pad regions 530 may include a conductive material. For example, each of the plurality of the storage-node pad regions 430 may include polysilicon. The polysilicon may also include at least one predetermined impurity for improving conductivity. The storage-node pad region 530 may include the same material as the bit-line pad region 430. Each of the plurality of the storage-node pad regions 530 may be disposed between two adjacent word-line structures 300. For example, each of the plurality of the storage-node pad regions 530 may contact both side surfaces of the two adjacent word-line structures 300 facing each other. The storage-node pad region 530 may overlap with the other end facing or opposite to the one end of the active region 100. In an arbitrary active region 100, the storage-node pad region 530 may contact one side of the word-line structure 300 overlapping the active region 100. The storage-node pad region 530 may also contact the word-line structure 300 overlapping the active region 100 that is spaced apart from the active region 100 in the second direction (Y). Some of the plurality of the storage-node pad regions 530 may be arranged spaced apart from each other in the first direction (X). Some others of the plurality of the storage-node pad regions 530 may be arranged spaced apart from each other in the second direction (Y).

Each of the plurality of the storage-node contact regions 540 may include a conductive material. For example, each of the plurality of the storage-node contact regions 540 may include at least one of polysilicon, aluminum, copper, and titanium. The polysilicon may include at least one predetermined impurity for improving conductivity. Each of the storage-node contact regions 540 may be arranged between two adjacent bit lines. The storage-node contact regions 540 may overlap with the other end of the active region 100. Some of the storage-node contact regions 540 may overlap with the word-line structure 300 that overlaps with the active region 100. Each of the plurality of the storage-node contact regions 540 may be arranged spaced apart from each other in the first direction (X). Each of the plurality of the storage-node contact regions 540 may be arranged spaced apart from each other in the second direction (Y).

FIG. 4 is a cross-sectional view illustrating a structure of the semiconductor device 1 taken along the line A-A' of FIGS. 2 and 3 based on an embodiment of the present disclosure.

Referring to FIGS. 2, 3 and 4, a first cross-section (CS1) may include a substrate region 10, an active region 100, a cell isolation region 200, a word-line structure 300, a bit-line structure 400, a storage-node pad region 530, a storage-node contact region 540, and a second pad insulation region 720.

The substrate region 10 may be a semiconductor region disposed below the active region 100. The substrate region 10 may include a semiconductor material. For example, the substrate region 10 may include at least one of silicon, silicon germanium, or a combination thereof.

The active region 100 may be spaced apart from a surface (i.e., a top surface in the drawings) of the semiconductor layer (SL) by a predetermined distance. The active region 100 may contact the side surface and the bottom surface of the word-line structure 300. For example, the active region 100 may surround at least a portion of the side surface and the bottom surface of the word-line insulation layer 340.

When a channel is formed in the active region 100, charge carriers may move from the bit-line electrode layer 410 to the bit-line contact region 440, the bit-line pad region 430, the active region 100, the storage-node pad region 530, and the storage-node contact region 540, and may finally move to the capacitor (not shown) (CAP in FIG. 1) connected above the storage-node contact region 540. Of course, such charge carriers may also move from the capacitor to the bit-line electrode layer 410 in a direction opposite to the above movement. Both side surfaces of the active region 100 may contact the cell isolation region 200.

The cell isolation region 200 may contact the side surface of the active region 100. The top surface of the cell isolation region 200 may contact the second pad insulation region 720. In an embodiment in which the bit-line pad region 430 or the storage-node pad region 530 is formed thicker in a horizontal direction than that illustrated in FIGS. 3 and 4, the top surface of the cell isolation region 200 may also contact the bit-line pad region 430 or the storage-node pad region 530.

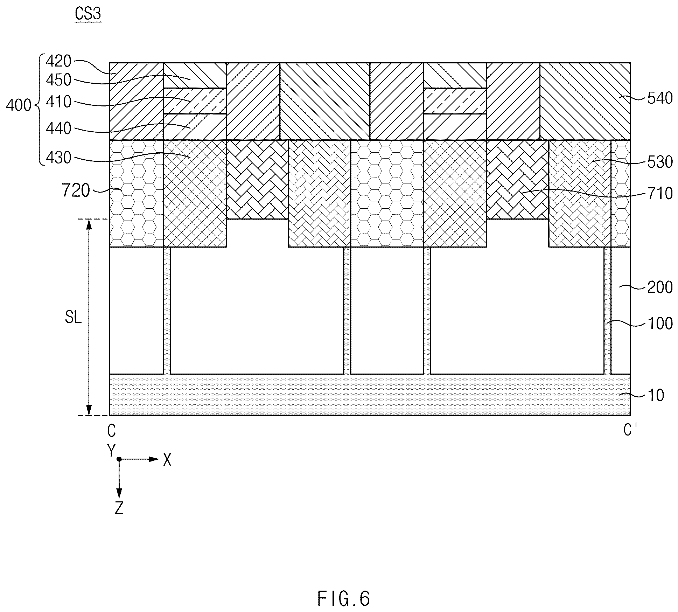

The word-line structure 300 may include a first word-line electrode layer 310, a second word-line electrode layer 320 formed over the first word-line electrode layer 310, a word-line capping layer 330 formed over the second word-line electrode layer 320, and a word-line insulation layer 340. The word-line insulation layer 340 may surround the bottom surface of the first word-line electrode layer 310, the side surface of the first word-line electrode layer 310, the side surface of the second word-line electrode layer 320, and the side surface of the word-line capping layer 330. The word-line structure 300 may extend (or be recessed) from the same plane as the top surface of the bit-line pad region 430 toward the inside of the semiconductor layer (SL) to a predetermined depth in the third direction (Z). The word-line structure 300 is preferably formed in the central region of the active region 100, but may vary depending on fabrication limitations, and variables. According to the present disclosure, the surface of the semiconductor layer (SL) may be defined as a position of the same plane as the surface where the bottom surface of the first pad insulation region 710 of FIG. 6 and the cell isolation region 200 contact each other.

The first word-line electrode layer 310 may include a conductive material. For example, the first word-line electrode layer 310 may include tungsten, aluminum, copper, tungsten nitride, tungsten silicide, cobalt silicide, titanium silicide, tantalum nitride, or a combination thereof. The first word-line electrode layer 310 may be disposed below the second word-line electrode layer 320. The side and bottom surfaces of the first word-line electrode layer 310 may be surrounded by the word-line insulation layer 340.

The second word-line electrode layer 320 may include a conductive material. For example, the second word-line electrode layer 320 may include tungsten, aluminum, copper, tungsten nitride, tungsten silicide, cobalt silicide, titanium silicide, tantalum nitride, or a combination thereof. The second word-line electrode layer 320 may be a region into which predetermined impurities (e.g., phosphorus, germanium, etc.) are implanted. The second word-line electrode layer 320 may be disposed on the first word-line electrode layer 310. The second word-line electrode layer 320 may be disposed below the word-line capping layer 330. Both side surfaces of the second word-line electrode layer 320 may contact the word-line insulation layer 340.

Although not shown in the drawings, a predetermined anti-oxidation layer may be arranged between the first word-line electrode layer 310 and the second word-line electrode layer 320. The predetermined anti-oxidation layer may capture (or collect) impurities (e.g., oxygen) contained in the first word-line electrode layer 310 and the second word-line electrode layer 320.

Each of the first word-line electrode layer 310 and the second word-line electrode layer 320 may receive a word-line signal as an input. When the word-line signal has a high level, a channel in which charges move may be formed around the word-line structure 300 within the active region 100. When the word-line signal has a low level, the channel may not be formed. When the channel is formed, the bit-line electrode layer 410 and the storage-node contact region 540 may be electrically connected to each other. For example, in an operation of recording data "1", when a high-level bit-line signal is applied to the bit-line electrode layer 410 and a word-line signal is applied to the first word-line electrode layer 310 and the second word-line electrode layer 320, charges may move to the storage-node contact region 540 according to the bit-line signal of the bit-line electrode layer 410 through the bit-line contact region 440, the bit-line pad region 430, the channel, and the storage-node pad region 530. Since the storage-node contact region 540 may be electrically connected to a predetermined capacitor structure (not shown), the charges may be stored in the capacitor structure through the storage-node contact region 540. The capacitor structure may be modeled in a circuit diagram as in the capacitor (CAP) of FIG. 1.

The word-line capping layer 330 may include an insulation material, such as, for example, silicon nitride, silicon oxide, silicon oxynitride, or a combination thereof. The word-line capping layer 330 may be disposed on the second word-line electrode layer 320. The word-line capping layer 330 may be a region filled with an insulation material between a surface of the semiconductor layer (SL) and a top surface of the second word-line electrode layer 320. The word-line capping layer 330 may electrically isolate the first word-line electrode layer 310 and the second word-line electrode layer 320 from the bit-line structure 400. The word-line capping layer 330 may electrically isolate the first word-line electrode layer 310 and the second word-line electrode layer 320 from the storage-node contact region 540. Although the depth of the word-line capping layer 330 from the surface of the semiconductor layer (SL) is depicted as shallower than the depth of the bit-line pad region 430 or the depth of the storage-node pad region 530 as shown in the drawings for convenience of description, other embodiments are also possible. According to another embodiment, the depth of the word-line capping layer 330 may also be formed deeper than the depth of the bit-line pad region 430 and the depth of the storage-node pad region 530.

The word-line insulation layer 340 may include an insulation material. For example, the word-line insulation layer 340 may include silicon oxide, hafnium oxide, hafnium silicon oxide, hafnium silicon oxynitride, or a combination thereof. The word-line insulation layer 340 may be formed along the side and bottom surfaces of the word-line structure 300. The word-line insulation layer 340 may physically isolate the first word-line electrode layer 310 and the second word-line electrode layer 320 from the active region 100. The word-line insulation layer 340 may electrically isolate the first word-line electrode layer 310 and the second word-line electrode layer 320 from the storage-node pad region 530.

The bit-line structure 400 may include a bit-line electrode layer 410, a bit-line spacer 420, a bit-line pad region 430, a bit-line contact region 440, and a bit-line capping layer 450. The bit line spacer 420 may surround the side surfaces of the bit-line electrode layer 410, the bit-line contact region 440, and the bit-line capping layer 450. The bit line pad region 430 may be in contact with an upper portion of the word-line structure 300.

The bit-line electrode layer 410 may include a conductive material. For example, the bit-line electrode layer 410 may include tungsten, aluminum, copper, tungsten nitride, tungsten silicide, cobalt silicide, titanium silicide, tantalum nitride, or a combination thereof. The bit-line electrode layer 410 may be arranged spaced apart from the surface of the semiconductor layer (SL). The bit-line electrode layer 410 may be arranged spaced apart from the bit-line pad region 430. The bit-line electrode layer 410 may overlap with the bit-line pad region 430 when viewed in the third direction (Z). The bit-line electrode layer 410 may overlap with the word-line structure 300. Each of the two side surfaces of the bit-line electrode layer 410 may contact the bit-line spacer 420. The bit-line electrode layer 410 may be disposed below the bit-line capping layer 450.

The bit-line spacer 420 may include an insulation material. For example, the bit-line spacer 420 may include at least one of silicon oxide, silicon nitride, silicon oxynitride, or a combination thereof. The bit-line spacer 420 may contact both side surfaces of the bit-line electrode layer 410. The bit-line spacer 420 may contact both side surfaces of the bit-line contact region 440. The bit-line spacer 420 may contact both side surfaces of the bit-line capping layer 450. The bit-line spacer 420 may electrically isolate the bit-line electrode layer 410 and the storage-node contact region 540 from each other. The bit-line spacer 420 may electrically isolate the bit-line contact region 440 and the storage-node contact region 540 from each other.

The bit-line pad region 430 may include a conductive material. For example, the bit-line pad region 430 may include polysilicon. The polysilicon may include at least one predetermined impurity. The bit-line pad region 430 may have a predetermined height extending from below the surface of the semiconductor layer (SL) to above the surface of the semiconductor layer (SL). The bottom surface of the bit-line pad region 430 may be disposed below the surface of the semiconductor layer (SL), and the top surface of the bit-line pad region 430 may be disposed above the surface of the semiconductor layer (SL). The bottom surface of the bit-line pad region 430 may contact the active region 100. One side of the bit-line pad region 430 may contact the word-line structure 300. The other side of the bit-line pad region 430 may contact the second pad insulation region 720. The bit-line pad region 430 may be disposed at the same level as the second pad insulation region 720.

In a situation where there is no bit-line pad region 430, when the word-line structure 300 is misaligned from the center of the active region 100 toward the bit-line contact region 440 (based on FIG. 4, when the word-line structure 300 is formed to be shifted (or biased) to the left), a contact area between the bit-line contact region 440 and the active region 100 may decrease in size, and there may occur various problems such as increased contact resistance, decreased current capacity, and performance degradation caused by increased temperature. However, when the bit-line pad region 430 is formed, the top surface of the bit-line pad region 430 may secure a contact area with the bit-line contact region 440, and the bottom surface of the bit-line pad region 430 may secure a contact area with the active region 100, so that the contact resistance is reduced, the current capacity is increased, and the temperature increase is lowered, thereby improving performance of the semiconductor device 1. Hence, including the bit-line pad region 430 compensates for misalignment issues, strengthening connectivity and improving electrical and thermal performance.

The bit-line contact region 440 may include a conductive material. For example, the bit-line contact region 440 may include at least one of polysilicon, copper, aluminum, titanium, titanium nitride, or a combination thereof. The bit-line contact region 440 may be formed of the same material as the bit-line electrode layer 410 or may be formed of a different material from the bit-line electrode layer 410. When the bit-line contact region 440 and the bit-line electrode layer 410 are formed of different materials, it may be more advantageous for the bit-line electrode layer 410 to select a metal material having high conductivity. In contrast, it may be more advantageous for the bit-line contact region 440 to select a material that is advantageous for reducing contact resistance between the bit-line electrode layer 410 and the bit-line pad region 430. The bit-line contact region 440 may contact the bottom surface of the bit-line electrode layer 410. Each of the two side surfaces of the bit-line contact region 440 may contact the bit-line spacer 420. The bottom surface of the bit-line contact region 440 may contact the bit-line pad region 430. The bit-line contact region 440 may be disposed on the surface of the semiconductor layer (SL).

The bit-line capping layer 450 may include an insulation material, such as, for example, silicon oxide, silicon nitride, silicon oxynitride, or a combination thereof. The bit-line capping layer 450 may contact the top surface of the bit-line electrode layer 410. The bit-line capping layer 450 may contact the bit-line spacer 420. The bit-line capping layer 450 together with the bit-line spacer 420 may prevent both the bit-line electrode layer 410 and the bit-line contact region 440 from electrically interacting with components disposed around the bit-line structure 400.

The storage-node pad region 530 may include a conductive material. For example, the storage-node pad region 530 may include polysilicon. The polysilicon may include at least one predetermined impurity. The storage-node pad region 530 may have a predetermined height extending from below the surface of the semiconductor layer (SL) to above the surface of the semiconductor layer (SL). The bottom surface of the storage-node pad region 530 may be disposed below the surface of the semiconductor layer (SL), and the top surface of the storage-node pad region 530 may be disposed above the surface of the semiconductor layer (SL). The bottom surface of the storage-node pad region 530 may contact the active region 100. One side of the storage-node pad region 530 may contact the second pad insulation region 720. The other side of the storage-node pad region 530 may contact the word-line structure 300, and more specifically the word-line insulation layer 340 of the word-line structure 300.

It is noted that if there is no storage-node pad region 530, and the word-line structure 300 is misaligned from the center of the active region 100 toward the storage-node contact region 540 (based on FIG. 4, then when the word-line structure 300 is formed to be shifted (or biased) to the right), the contact area between the storage-node contact region 540 and the active region 100 may decrease in size, and there may occur various problems such as increased contact resistance, decreased current capacity, and performance degradation caused by increased temperature. However, by including the storage-node pad region 530, the top surface of the storage-node pad region 530 may secure a contact area with the storage-node contact region 540, and the bottom surface of the storage-node pad region 530 may secure a contact area with the active region 100, so that the contact resistance is reduced, the current capacity is increased, and the temperature increase is lowered, thereby improving the overall performance of the semiconductor device 1.

The storage-node contact region 540 may include a conductive material. For example, the storage-node contact region 540 may include at least one of polysilicon, copper, aluminum, titanium, titanium nitride, or a combination thereof. The bottom surface of the storage-node contact region 540 may contact the storage-node pad region 530. The bottom surface of the storage-node contact region 540 may also contact the top surface of the second pad insulation region 720, the top surface of the word-line capping layer 330 and the top surface of the word-line insulation layer 340. One side surface of the storage-node contact region 540 may contact the bit-line spacer 420, and more specifically a side surface of the bit-line spacer 420.

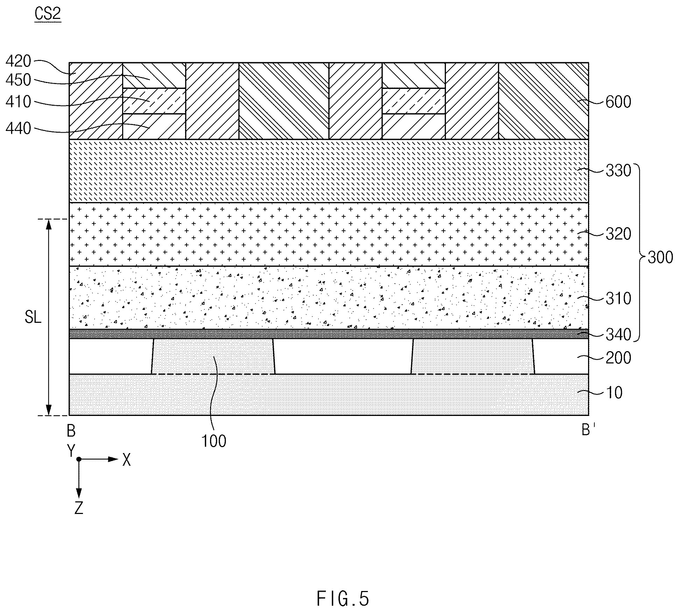

In the following description of FIGS. 5 to 18F, descriptions overlapping with those described in FIGS. 1 to 4 may be omitted.

FIG. 5 is a cross-sectional view illustrating a structure of the semiconductor device taken along the line B-B' of FIGS. 2 and 3 based on an embodiment of the present disclosure.

Referring to FIGS. 2, 3, 4, and 5, the second cross-section (CS2) may include a substrate region 10, an active region 100, a cell isolation region 200, a first word-line electrode layer 310, a second word-line electrode layer 320, a word-line capping layer 330, a word-line insulation layer 340, a bit-line electrode layer 410, a bit-line spacer 420, a bit-line contact region 440, a bit-line capping layer 450, and a contact insulation region 600.

The first word-line electrode layer 310 may extend in the first direction (X). The first word-line electrode layer 310 may be disposed on the word-line insulation layer 340. The second word-line electrode layer 320 may extend in the first direction (X). The second word-line electrode layer 320 may be disposed on the first word-line electrode layer 310. The word-line capping layer 330 may extend in the first direction (X). The word-line capping layer 330 may be disposed on the second word-line electrode layer 320. The word-line insulation layer 340 may extend in the first direction (X). The bottom surface of the word-line insulation layer 340 may contact the top surfaces of each of the cell isolation regions 200 and the active regions 100.

In FIG. 5, the bottom surface of the word-line insulation layer 340 is illustrated as being formed horizontally, but other embodiments are also possible. Alternatively, depending on the process methods, the etching speed of the active region 100 and the etching speed of the cell isolation region 200 may be different from each other, and the bottom surface of the word-line insulation layer 340 may be located at a lower position over the cell isolation region 200 than over the active region 100 (i.e., the word-line insulation layer 340 may be located at a deeper position over the cell isolation region 200 than over the active region 100). Hereinafter, the present disclosure will describe an embodiment in which the bottom surface of the word-line insulation layer 340 is formed horizontally.

A plurality of bit-line electrode layers 410 may be arranged spaced apart from each other in the first direction (X). Both side surfaces of each of the plurality of the bit-line electrode layers 410 may contact the bit-line spacers 420. The contact insulation region 600 may be disposed between the bit-line spacers 420 arranged on one side surfaces of the different bit-line electrode layers 410. The contact insulation region 600 may be disposed between the bit-line spacers 420 in the first direction (X).

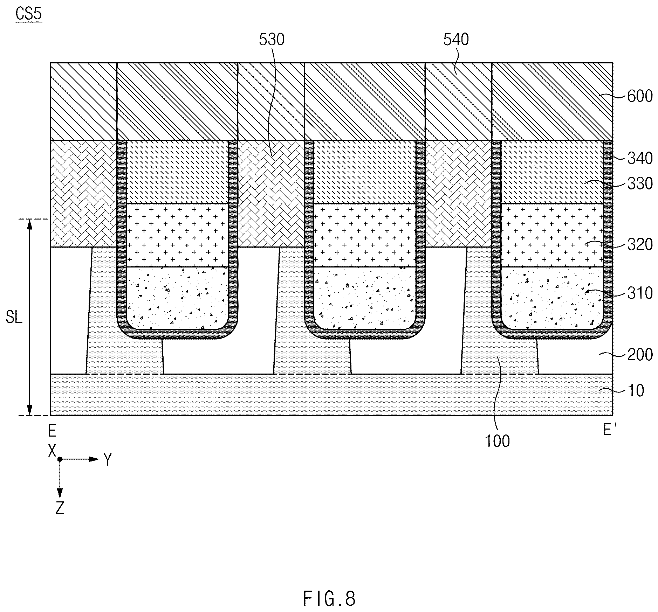

The contact insulation region 600 may include an insulation material. For example, the contact insulation region 600 may include at least one of silicon oxide, silicon nitride, silicon oxynitride, or a combination thereof. The contact insulation region 600 will be described in more detail later with reference to FIG. 8.

FIG. 6 is a cross-sectional view illustrating a structure of the semiconductor device taken along the line C-C' of FIGS. 2 and 3 based on an embodiment of the present disclosure.

Referring to FIGS. 2, 3, 4, and 6, the third cross-section (CS3) may include a substrate region 10, an active region 100, a cell isolation region 200, a bit-line electrode layer 410, a bit-line spacer 420, a bit-line pad region 430, a bit-line contact region 440, a bit-line capping layer 450, a storage-node pad region 530, a storage-node contact region 540, a first pad insulation region 710, and a second pad insulation region 720.

The bottom surface of the bit-line pad region 430 may contact the top surfaces of the active region 100 and the cell isolation region 200. A portion of one side (e.g., the right side in FIG. 6) of the bit-line pad region 430 may contact the cell isolation region 200. Another portion of the one side of the bit-line pad region 430 may contact the first pad insulation region 710. The other side (e.g., the left side in FIG. 6) of the bit-line pad region 430 may contact the second pad insulation region 720. The top surface of the bit-line pad region 430 may contact the bit-line contact region 440.

The storage-node pad region 530 may contact the top surface of the active region 100. A portion of one side (e.g., the left side in FIG. 6) of the storage-node pad region 530 may contact the cell isolation region 200. Another portion of the other side of the storage-node pad region 530 may contact the first pad insulation region 710. The other side (e.g., the right side in FIG. 6) of the storage-node pad region 530 may contact the second pad insulation region 720.

The plurality of the bit-line pad regions 430 and the plurality of the storage-node pad regions 530 may be alternately arranged in the first direction (X). The bit-line pad region 430 may have the same height as the storage-node pad region 530, but the embodiments of the present disclosure are not limited thereto. For example, the height of the bit-line pad region 430 may be greater than or equal to the height of the storage-node pad region 530. The bottom surface of the bit-line pad region 430 may be located at a lower position than the bottom surface of the first pad insulation region 710. The bottom surface of the storage-node pad region 530 may be located lower than the bottom surface of the first pad insulation region 710. The bottom surface of the bit-line pad region 430 may be located at the same plane as the bottom surface of the second pad insulation region 720. The bottom surface of the storage-node pad region 530 may be located at the same plane as the bottom surface of the second pad insulation region 720.

Each of the two side surfaces of the storage-node contact region 540 may contact the bit-line spacer 420. The bottom surface of the storage-node contact region 540 may contact the storage-node pad region 530. In an embodiment, a portion of the bottom surface of the storage-node contact region 540 may contact the first pad insulation region 710, the second pad insulation region 720, or both.

Each of the plurality of bit-line contact regions 440 may contact the top surface of the bit-line pad region 430. On the other hand, each of the plurality of the storage-node contact regions 540 may contact the top surface of the storage-node pad region 530.

The first pad insulation region 710 may include an insulation material. For example, the first pad insulation region 710 may include at least one of silicon oxide, silicon nitride, silicon oxynitride, or a combination thereof. The first pad insulation region 710 may be disposed between the bit-line pad region 430 and the storage-node pad region 530. The first pad insulation region 710 may contact one side of the bit-line pad region 430. The first pad insulation region 710 may contact one side (e.g., the right side in FIG. 6) of the bit-line pad region 430 facing the first direction (X). The first pad insulation region 710 may contact one side of the storage-node pad region 530. The first pad insulation region 710 may contact one side (e.g., the left side in FIG. 6) of the storage-node pad region 530 facing the opposite direction to the first direction (X). The first pad insulation region 710 may be formed to a first height from the top surface of the cell isolation region 200 (i.e., the top surface of the semiconductor layer SL). For example, the top surface of the first pad insulation region 710 may be disposed at the same plane as the top surface of the bit-line pad region 430.

The second pad insulation region 720 may include an insulation material. For example, the second pad insulation region 720 may include at least one of silicon oxide, silicon nitride, silicon oxynitride, or a combination thereof. For example, the second pad insulation region 720 may include the same material as the first pad insulation region 710. The second pad insulation region 720 may be disposed between the bit-line pad region 430 and the storage-node pad region 530 which are adjacent to each other in the first direction (X). The second pad insulation region 720 may contact the other side of the bit-line pad region 430. The second pad insulation region 720 may contact the side surface of the bit-line pad region 430 facing the direction opposite to the first direction (X). The second pad insulation region 720 may contact the other side of the storage-node pad region 530. The second pad insulation region 720 may contact the side surface of the storage-node pad region 530 facing the first direction (X). The second pad insulation region 720 may be formed to a second height. For example, the top surface of the second pad insulation region 720 may be disposed at the same plane as the top surface of the bit-line pad region 430. The bottom surface of the second pad insulation region 720 may be located lower than the top surface of the semiconductor layer (SL).

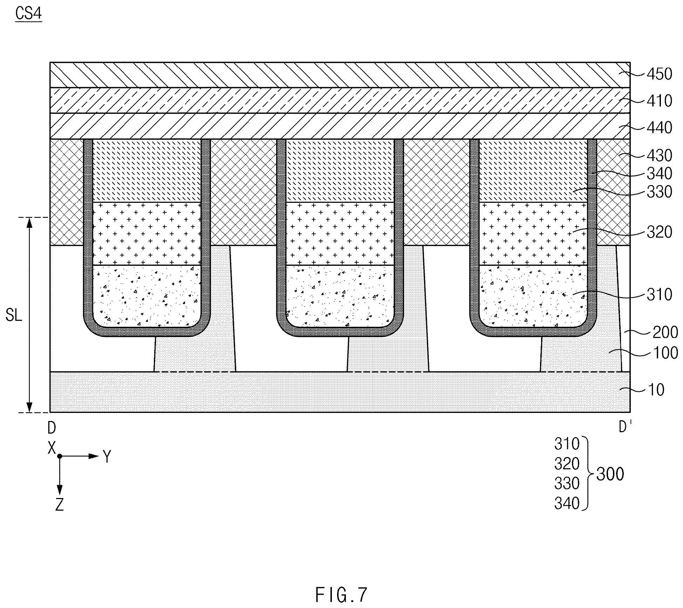

FIG. 7 is a cross-sectional view illustrating a structure of the semiconductor device 1 taken along the line D-D' of FIGS. 2 and 3 based on an embodiment of the present disclosure.

Referring to FIGS. 2, 3, 4, and 7, the fourth cross-section (CS4) may include a substrate region 10, an active region 100, a cell isolation region 200, a bit-line pad region 430, a first word-line electrode layer 310, a second word-line electrode layer 320, a word-line capping layer 330, a word-line insulation layer 340, a bit-line electrode layer 410, a bit-line contact region 440, and a bit-line capping layer 450.

The bit-line electrode layer 410 may extend in the second direction (Y). The bit-line contact region 440 may extend in the second direction (Y). The bit-line capping layer 450 may extend in the second direction (Y).

A portion (e.g., a lower portion) of the bottom surface of the word-line structure 300 may contact the active region 100. Another portion of the bottom surface of the word-line structure 300 may contact the cell isolation region 200. A portion (e.g., a lower portion) of one side of the word-line structure 300 may contact the active region 100. Another portion (e.g., an upper portion) of one side of the word-line structure 300 may contact the bit-line pad region 430. A portion (e.g., a lower portion) of the other side of the word-line structure 300 may contact the cell isolation region 200. Another portion (e.g., an upper portion) of the other side of the word-line structure 300 may contact the bit-line pad region 430.

Each of the plurality of the bit-line pad regions 430 may be disposed between adjacent word-line structures 300.

FIG. 8 is a cross-sectional view illustrating a structure of the semiconductor device 1 taken along the line E-E' of FIGS. 2 and 3 based on an embodiment of the present disclosure.

Referring to FIGS. 2, 3, 4, and 8, the fifth cross-section (CS5) may include a substrate region 10, an active region 100, a cell isolation region 200, a word-line structure 300, a storage-node pad region 530, a storage-node contact region 540, and a contact insulation region 600.

Both side surfaces of each of the plurality of the storage-node contact regions 540 may contact the side surfaces of the contact insulation regions 600. Both side surfaces of each of the plurality of contact insulation regions 600 may contact the storage-node contact region 540. The plurality of the storage-node contact regions 540 and the plurality of contact insulation regions 600 may be alternately and repeatedly arranged in the second direction (Y).

The active region 100 may contact a portion of the bottom surface of the word-line structure 300 and a portion (e.g., a lower portion) of one side surface (e.g., the left side in FIG. 8) of the word-line structure 300. The cell isolation region 200 may contact another portion of the bottom surface of the word-line structure 300 and a portion (e.g., a lower portion) of another side surface (e.g., the right side in FIG. 8) of the word-line structure 300.

The storage-node pad region 530 may contact a portion (e.g., an upper portion) of one side of the word-line structure 300. The storage-node pad region 530 may contact a portion (e.g., an upper portion) of the other side of the word-line structure 300. The storage-node pad regions 530 may be disposed in an alternating manner with the word-line structures 300 along the second direction (Y).

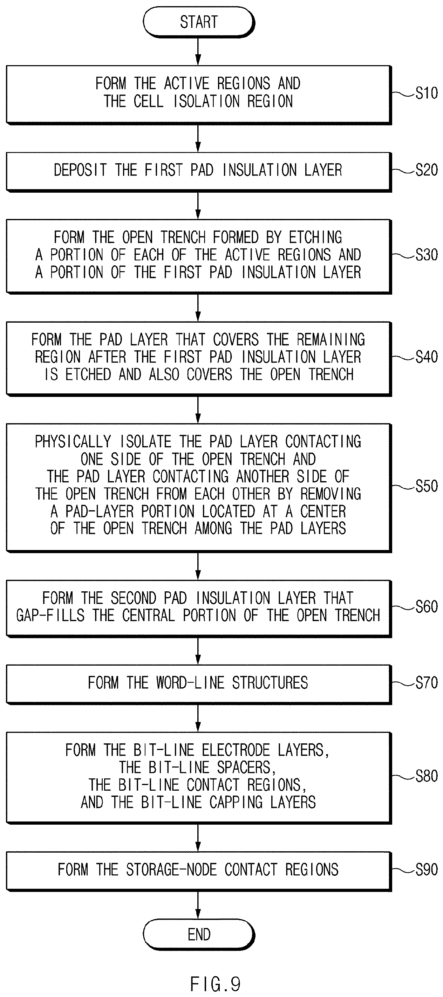

FIG. 9 is a flowchart illustrating a method for manufacturing the semiconductor device 1 based on an embodiment of the present disclosure.

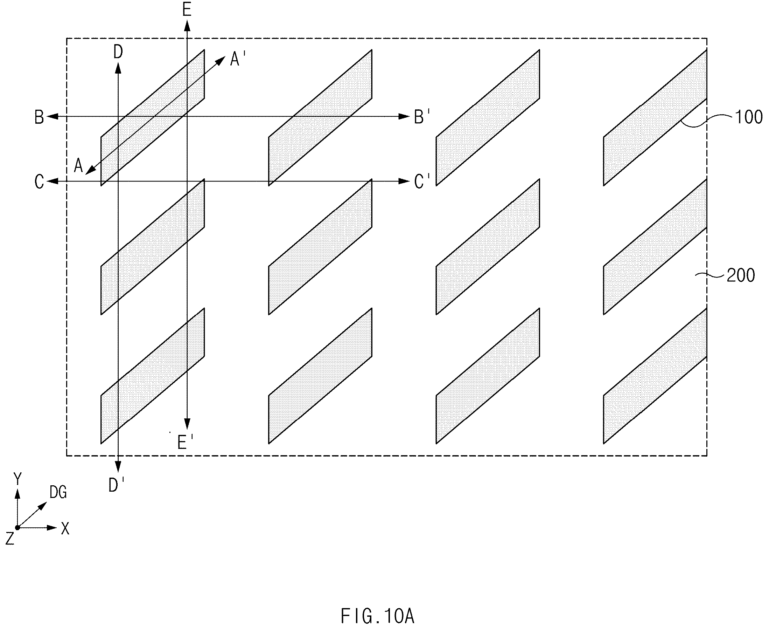

FIGS. 10A to 18F are plan views or cross-sectional views illustrating a method for manufacturing the semiconductor device 1 shown in FIG. 9.

FIG. 10A is a plan view illustrating a result of performing operation S10 of FIG. 9 based on an embodiment of the present disclosure.

Referring to FIGS. 2, 3, 9, and 10A to 10F, a method for manufacturing the semiconductor device 1 (hereinafter referred to as "the present manufacturing method") may include forming (S10) a plurality of active regions 100 and a cell isolation region 200 surrounding the plurality of the active regions 100.

Referring to FIG. 10A, some of the plurality of the active regions 100 may be repeatedly arranged spaced apart from each other in the first direction (X). Some others of the plurality of the active regions 100 may be repeatedly arranged spaced apart from each other in the second direction (Y) that is perpendicular to the first direction (X). Other parts of the plurality of the active regions 100 may be repeatedly arranged spaced apart from each other in a diagonal direction (DG). Each of the plurality of the active regions 100 may extend in the diagonal direction (DG). An angle between the diagonal direction (DG) and the first direction (X) may be in a range of about 30 degrees to about 60 degrees.

Thereafter, a cell isolation region 200 may be formed to gap-fill the remaining empty spaces except for the plurality of the active regions 100 with an insulation material, such as, for example, e.g., silicon oxide, silicon nitride, silicon oxynitride and the like.

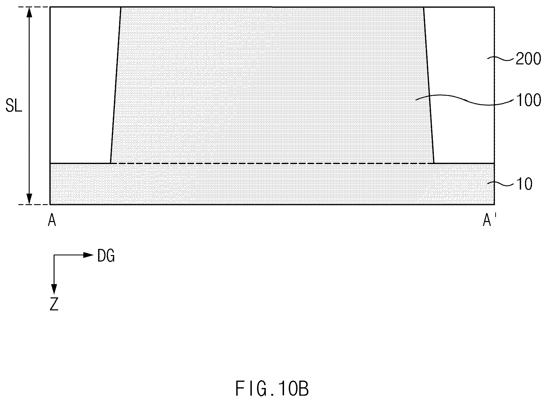

FIG. 10B is a cross-sectional view illustrating a structure of the semiconductor device 1 taken along the line A-A' of FIG. 10A based on an embodiment of the present disclosure.

Referring to FIGS. 10A and 10B, a predetermined trench may be formed from the top surface of the semiconductor layer (SL) including a semiconductor material, such as, for example, silicon, silicon germanium, and the like. The remaining region after formation of the trench may be the active region 100 or the substrate region 10. In an embodiment, the active region 100 may be defined as a region having the same depth as the predetermined trench. In the present disclosure, the substrate region 10 may contact the bottom surface of the active region 100, and may be defined as the remaining region except for the active region 100 after the predetermined trench is formed.

After the predetermined trench is formed, the cell isolation region 200 formed by gap-filling the trench with an insulation material.

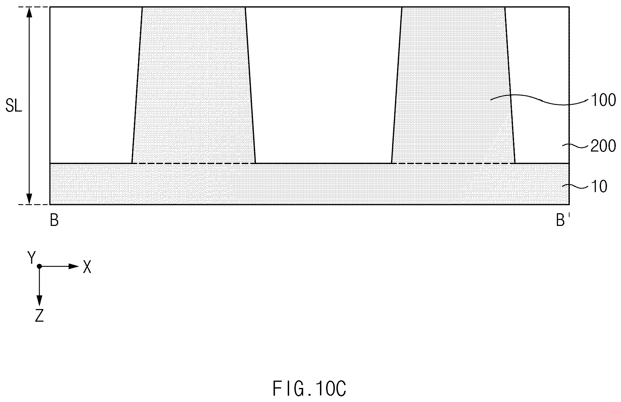

FIG. 10C is a cross-sectional view illustrating a structure of the semiconductor device taken along the line B-B' of FIG. 10A based on an embodiment of the present disclosure.

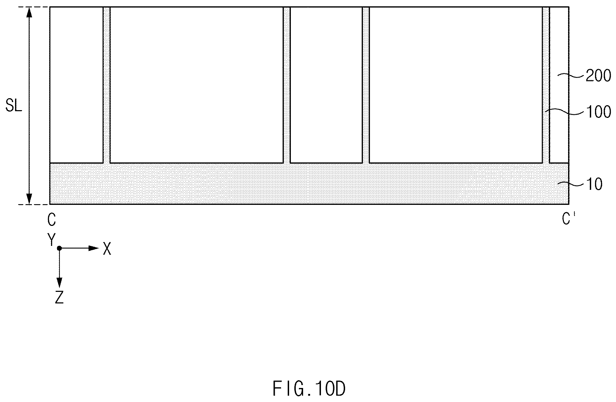

FIG. 10D is a cross-sectional view illustrating a structure of the semiconductor device taken along the line C-C' of FIG. 10A based on an embodiment of the present disclosure.

Referring to FIGS. 10A, 10C, and 10D, the plurality of the active regions 100 may be repeatedly formed in the first direction (X) by an operation of forming the predetermined trench. The cell isolation region 200 may be formed between the plurality of the active regions 100.

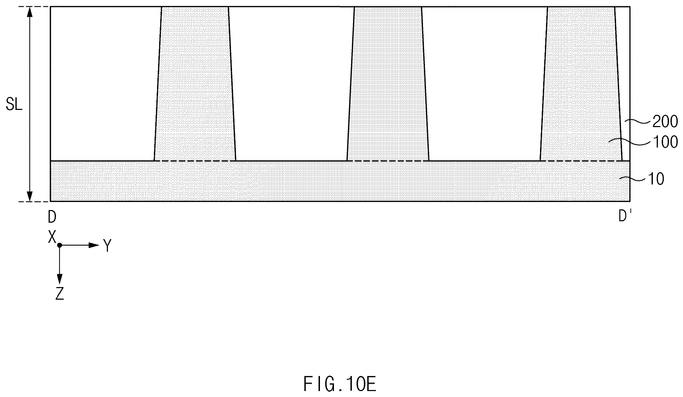

FIG. 10E is a cross-sectional view illustrating a structure of the semiconductor device 1 taken along the line D-D' of FIG. 10A based on an embodiment of the present disclosure.

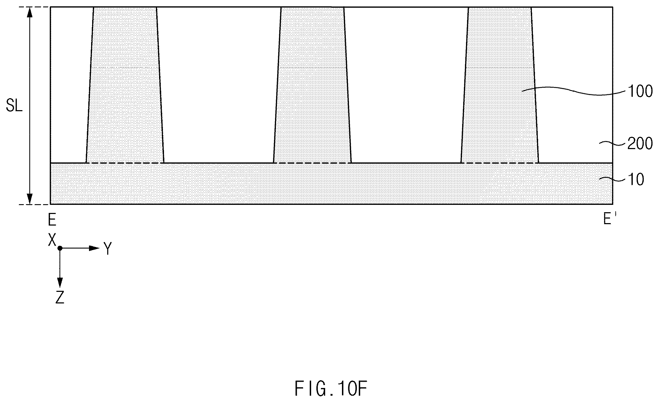

FIG. 10F is a cross-sectional view illustrating a structure of the semiconductor device 1 taken along the line E-E' of FIG. 10A based on an embodiment of the present disclosure.

Referring to FIGS. 10A, 10E, and 10F, the plurality of the active regions 100 may be repeatedly formed in the second direction (Y) by the operation of forming the predetermined trench 100. The cell isolation region 200 may be formed between the plurality of the active regions 100.

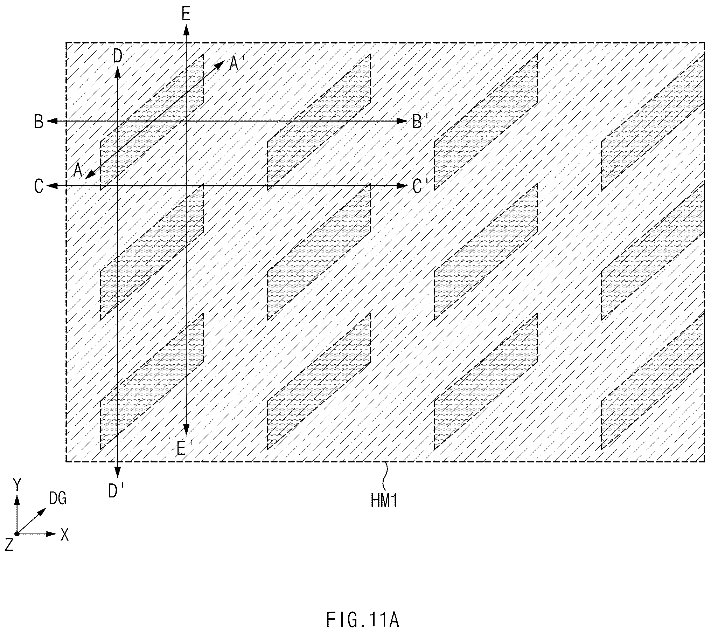

The following embodiments of FIGS. 11A to 11F will hereinafter be described with a focus on the characteristics that are different from those of FIGS. 10A to 10F.

FIG. 11A is a plan view illustrating a result of performing operation S20 of FIG. 9 based on an embodiment of the present disclosure.

Referring to FIGS. 2, 3, 9, and 11A to 11F, the present manufacturing method may include depositing (S20) a first pad insulation layer (HM1) over the plurality of the active regions 100 and the cell isolation region 200.

Referring to FIGS. 10A and 11A, the first pad insulation layer (HM1) overlapping each of the cell isolation region 200 and the plurality of the active regions 100 may be deposited. The first pad insulation layer (HM1) may include the same material as the first pad insulation region 710 shown in FIG. 3.

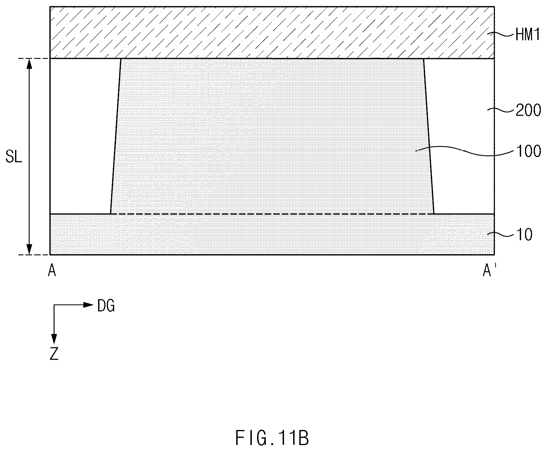

FIG. 11B is a cross-sectional view illustrating a structure of the semiconductor device 1 taken along the line A-A' of FIG. 11A based on an embodiment of the present disclosure.

Referring to FIGS. 10A, 11A, and 11B, the first pad insulation layer (HM1) may be deposited on the top surface of the semiconductor layer (SL). The first pad insulation layer (HM1) may be disposed on the top surface of the semiconductor layer (SL) to a predetermined thickness.

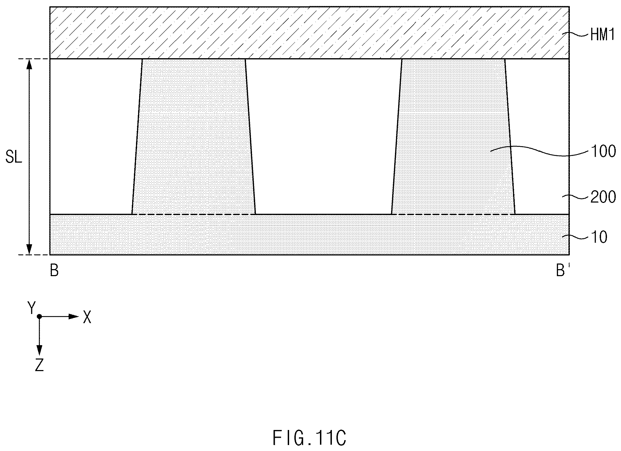

FIG. 11C is a cross-sectional view illustrating a structure of the semiconductor device 1 taken along the line B-B' of FIG. 11A based on an embodiment of the present disclosure.

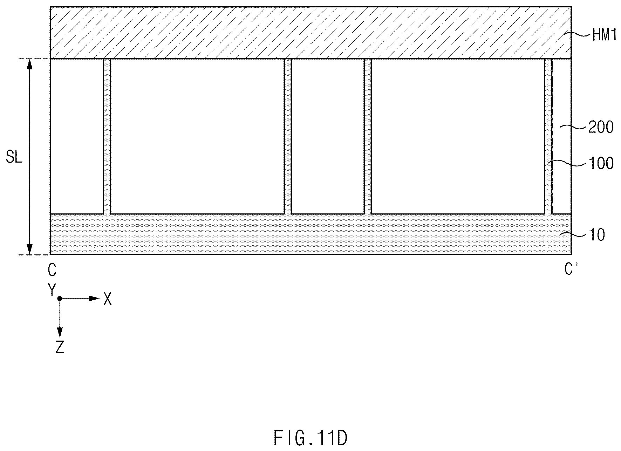

FIG. 11D is a cross-sectional view illustrating a structure of the semiconductor device 1 taken along the line C-C' of FIG. 11A based on an embodiment of the present disclosure.

Referring to FIGS. 10A, 11A, 11C, and 11D, the first pad insulation layer (HM1) may extend in the first direction (X) from the top surface of the semiconductor layer (SL), and may be deposited over the top surface of the semiconductor layer (SL).

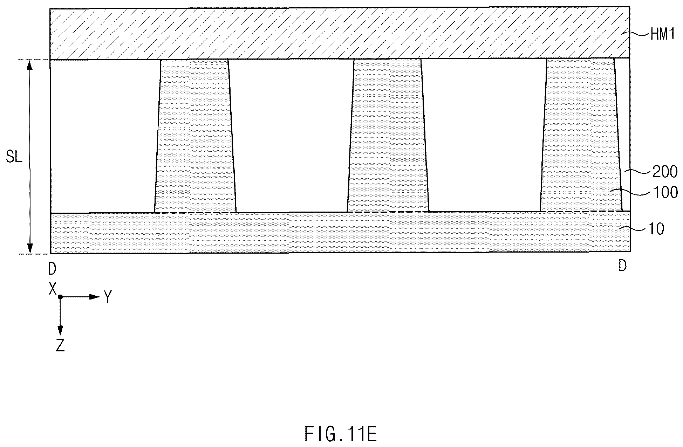

FIG. 11E is a cross-sectional view illustrating a structure of the semiconductor device 1 taken along the line D-D' of FIG. 11A based on an embodiment of the present disclosure.

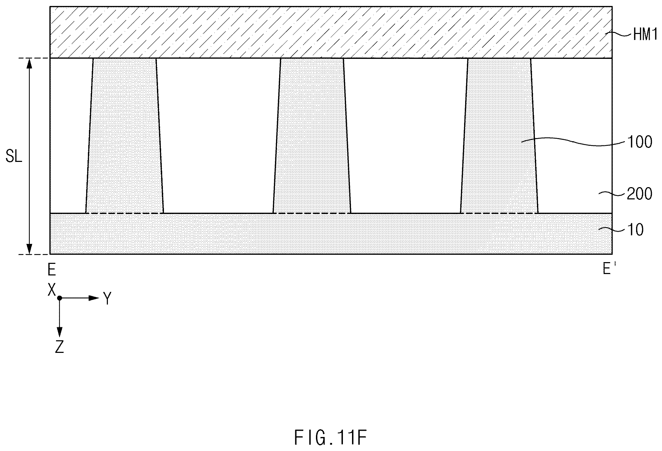

FIG. 11F is a cross-sectional view illustrating a structure of the semiconductor device 1 taken along the line E-E' of FIG. 11A based on an embodiment of the present disclosure.

Referring to FIGS. 10A, 11A, 11E, and 11F, the first pad insulation layer (HM1) may extend in the second direction (Y) from the top surface of the semiconductor layer (SL), and may be deposited over the top surface of the semiconductor layer (SL).

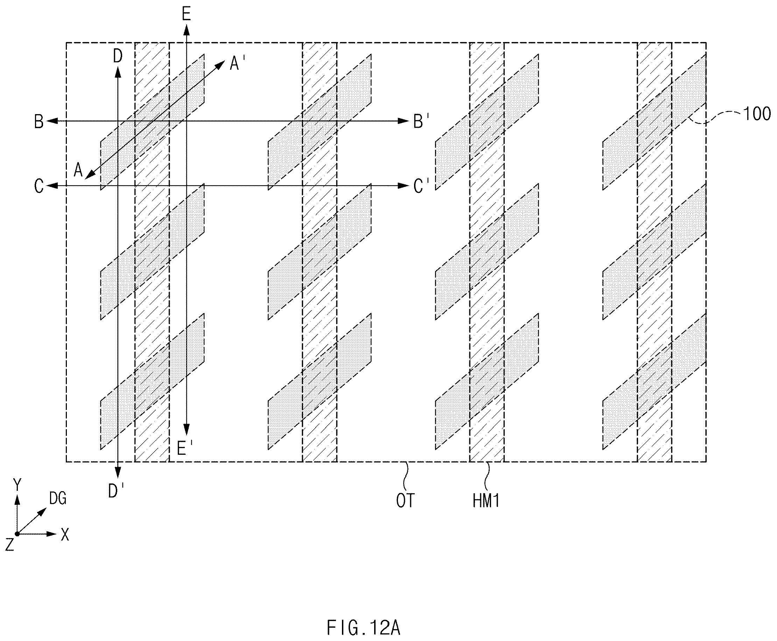

The following embodiments of FIGS. 12A to 12F will hereinafter be described with a focus on the characteristics that are different from those of FIGS. 11A to 11F.

FIG. 12A is a plan view illustrating a result of performing operation S30 of FIG. 9 based on an embodiment of the present disclosure.

Referring to FIGS. 2, 3, 9, and 12A to 12F, the present manufacturing method may include forming (S30) an open trench (OT) by etching a portion of each of the plurality of the active regions 100 and a portion of the first pad insulation layer (HM1).

Referring to FIGS. 11A and 12A, the open trench (OT) may be formed to overlap with a portion of each of two active regions 100 adjacent to each other in the first direction (X). In FIG. 12A, the portion of the active region 100 that overlaps with the left portion of each of the plurality of the open trenches (OTs) may be a portion that overlaps with the storage-node contact region 540 and the storage-node pad region 530 shown in FIG. 2.

In FIG. 12A, the portion of the active region 100 that overlaps with the right portion of each of the plurality of the open trenches (OTs) may be a portion that overlaps with the bit-line electrode layer 410 of FIG. 2 and the bit-line pad region 430 of FIG. 3.

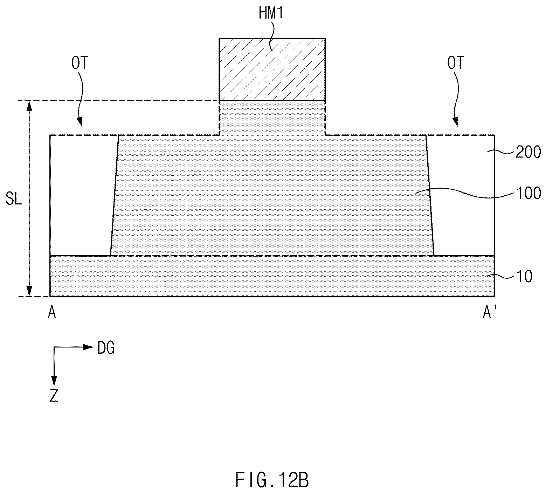

FIG. 12B is a cross-sectional view illustrating a structure of the semiconductor device 1 taken along the line A-A' of FIG. 12A based on an embodiment of the present disclosure.

Referring to FIGS. 11A, 12A, and 12B, some of the plurality of the open trenches (OTs) may be trenches formed when one end (e.g., the left side in FIG. 12B) of the active region 100 is etched to a predetermined depth. Each of the open trenches (OTs) may also be a trench in which a portion of the cell isolation region 200 contacting one end of the active region 100 is etched to the predetermined depth. The portion of the etched cell isolation region 200 and a portion of the first pad insulation layer (HM1) disposed on the etched portion of the active region 100 are also etched and removed together.

Other portions of the plurality of the open trenches (OTs) may be trenches formed when the other end (e.g., the right side in FIG. 12B) of the active region 100 is etched to the predetermined depth. Each open trench (OT) may be a trench formed when the other portion of the cell isolation region 200 contacting the other end of the active region is also etched to the predetermined depth. The other portion of the etched cell isolation region 200 and a portion of the first pad insulation layer (HM1) disposed on the etched active region 100 are also etched and removed together.

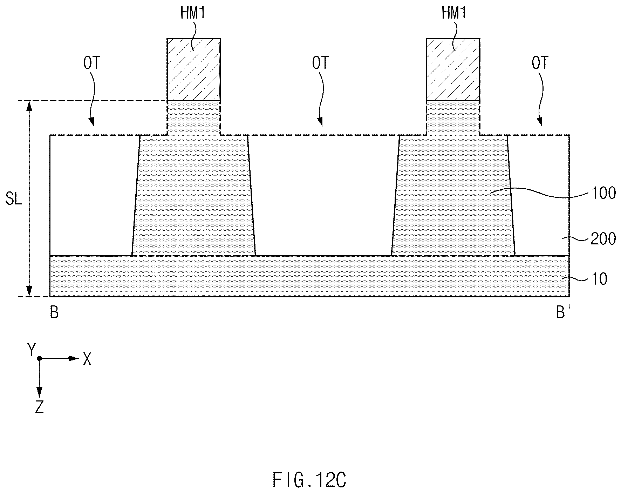

FIG. 12C is a cross-sectional view illustrating a structure of the semiconductor device taken along the line B-B' of FIG. 12A based on an embodiment of the present disclosure.

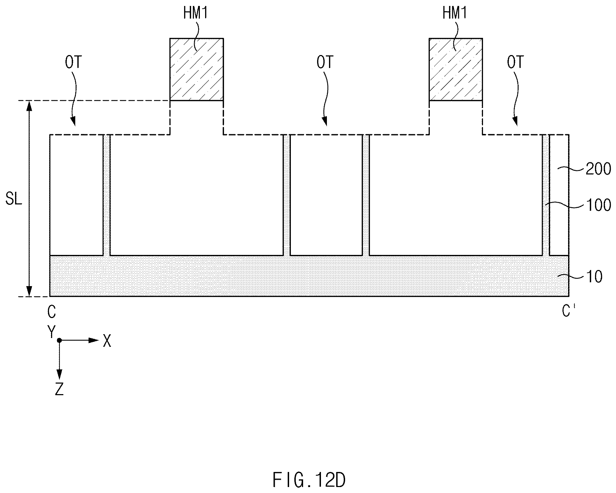

FIG. 12D is a cross-sectional view illustrating a structure of the semiconductor device taken along the line C-C' of FIG. 12A based on an embodiment of the present disclosure.

Referring to FIGS. 11A, 12A, 12C, and 12D, each of the plurality of the open trenches (OTs) may be recessed from the surface of the first pad insulation layer (HM1) into the interior of the semiconductor layer (SL). Each of the plurality of the open trenches (OTs) may be formed to overlap with a portion of each of the two adjacent active regions 100. Each of the plurality of the open trenches (OTs) may be repeatedly formed spaced apart from each other in the first direction (X).

Since the open trench (OT) is formed across a portion of each of the two active regions 100 adjacent to each other in the first direction (X), the open trench (OT) may have a relatively large width in the first direction (X), and when considering a minimum pitch at which the etching process is possible, a process burden of the open trench (OT) can be reduced. Thus, the wider trench layout across adjacent active regions simplifies etching, improving manufacturability.

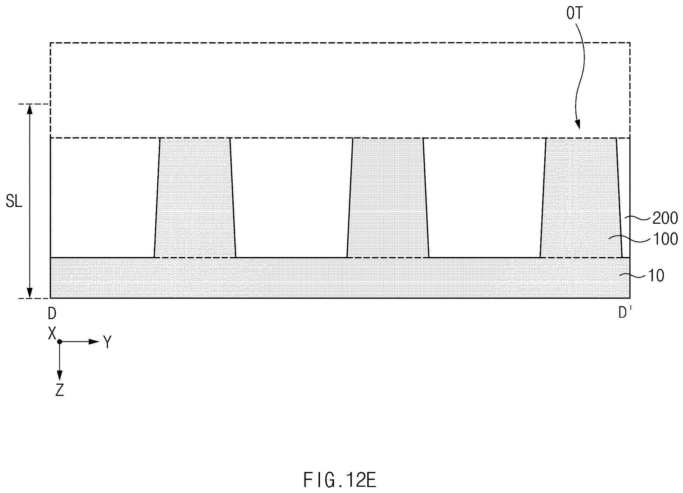

FIG. 12E is a cross-sectional view illustrating a structure of the semiconductor device 1 taken along the line D-D' of FIG. 12A based on an embodiment of the present disclosure.

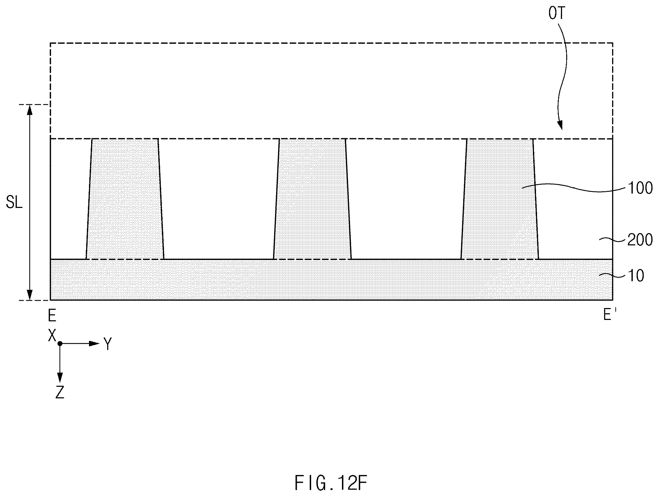

FIG. 12F is a cross-sectional view illustrating a structure of the semiconductor device 1 taken along the line E-E' of FIG. 12A based on an embodiment of the present disclosure.

Referring to FIGS. 11A, 12A, 12E, and 12F, the open trench (OT) may extend in the second direction (Y).

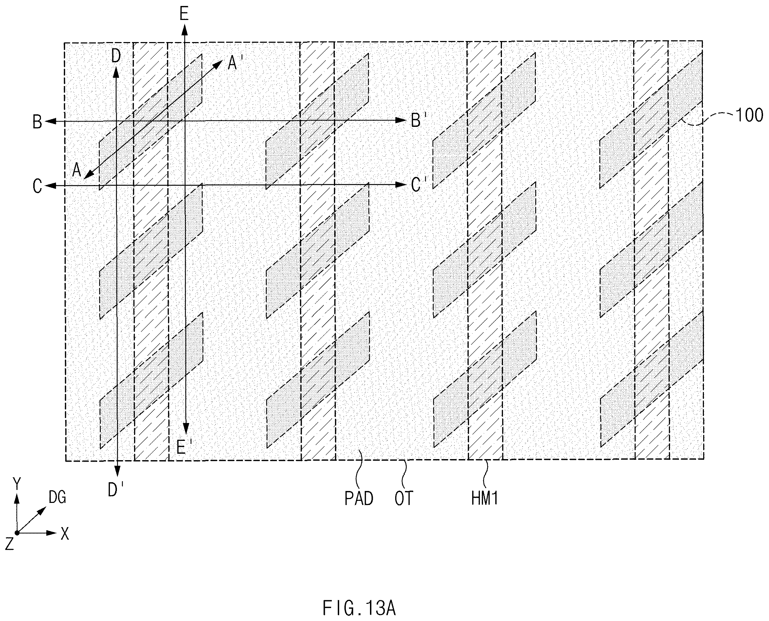

The following embodiments of FIGS. 13A to 13F will hereinafter be described with a focus on the characteristics that are different from those of FIGS. 12A to 12F.

FIG. 13A is a plan view illustrating a result of performing operation S40 of FIG. 9 based on an embodiment of the present disclosure.

Referring to FIGS. 2, 3, 9, and 13A to 13F, the present manufacturing method may include forming (S40) a pad layer (PAD) covering the first pad insulation layer (HM1) and the open trench (OT).

Referring to FIGS. 12A and 13A, the pad layer (PAD) may be disposed in the open trench (OT). The pad layer (PAD) may include the same material (e.g., polysilicon) as the bit-line pad region 430 and the storage-node pad region 530 shown in FIG. 3.

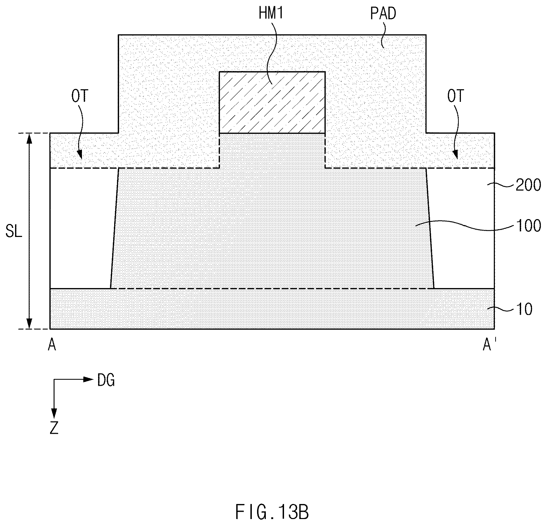

FIG. 13B is a cross-sectional view illustrating a structure of the semiconductor device 1 taken along the line A-A' of FIG. 13A based on an embodiment of the present disclosure.

Referring to FIGS. 12A, 13A, and 13B, the pad layer (PAD) may cover the top surface and both side surfaces of the first pad insulation layer (HM1). The pad layer (PAD) may be formed along the inner wall of the open trench (OT). The pad layer (PAD) may have a predetermined height from the bottom surface of the open trench (OT) when viewed in the third direction (Z).

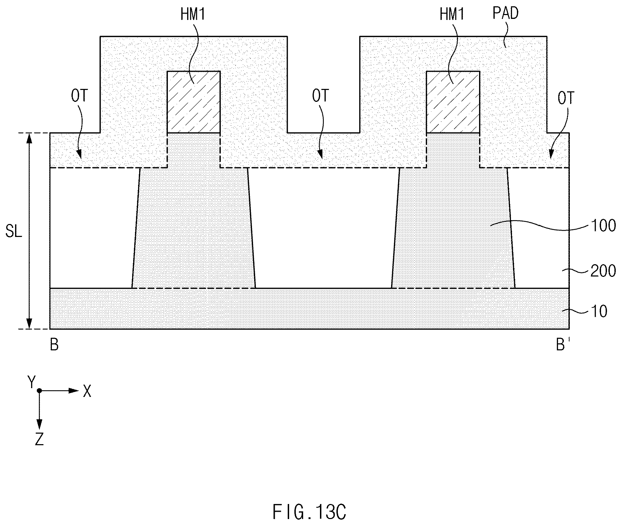

FIG. 13C is a cross-sectional view illustrating a structure of the semiconductor device 1 taken along the line B-B' of FIG. 13A based on an embodiment of the present disclosure.

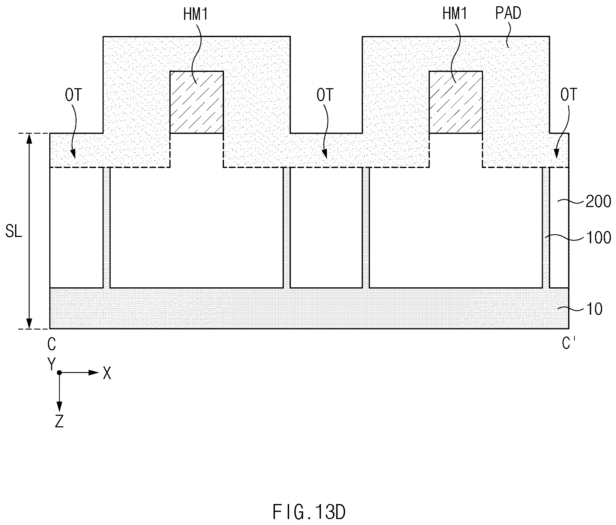

FIG. 13D is a cross-sectional view illustrating a structure of the semiconductor device 1 taken along the line C-C' of FIG. 13A based on an embodiment of the present disclosure.

Referring to FIGS. 12A, 13A, 13C and 13D, a pad layer (PAD) may be formed to cover the bottom and side surfaces of the open trench (OT) and the top and side surfaces of the first pad insulation layer (HM1) in the first direction (X).

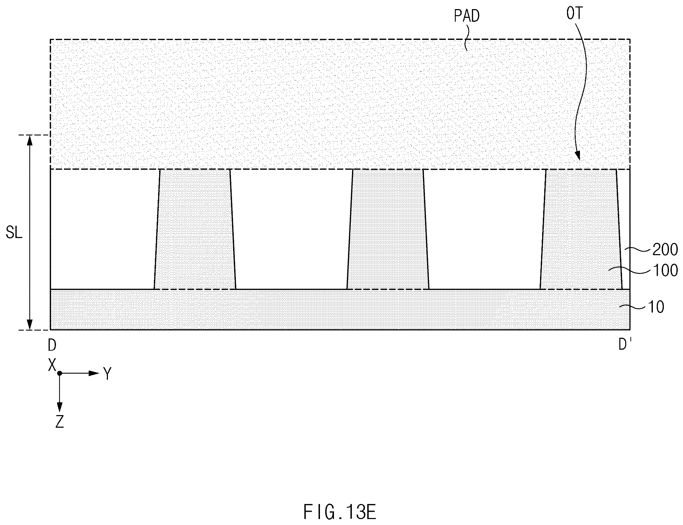

FIG. 13E is a cross-sectional view illustrating a structure of the semiconductor device 1 taken along the line D-D' of FIG. 13A based on an embodiment of the present disclosure.

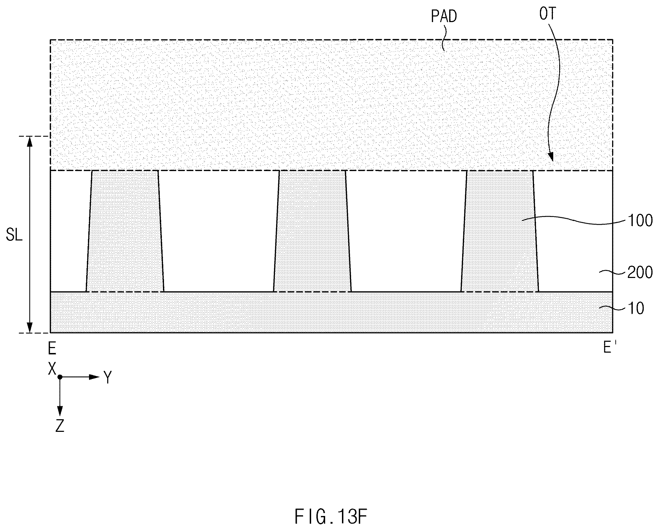

FIG. 13F is a cross-sectional view illustrating a structure of the semiconductor device 1 taken along the line E-E' of FIG. 13A based on an embodiment of the present disclosure.

Referring to FIGS. 12A, 13A, 13E, and 13F, the pad layer (PAD) may extend in the second direction (Y).

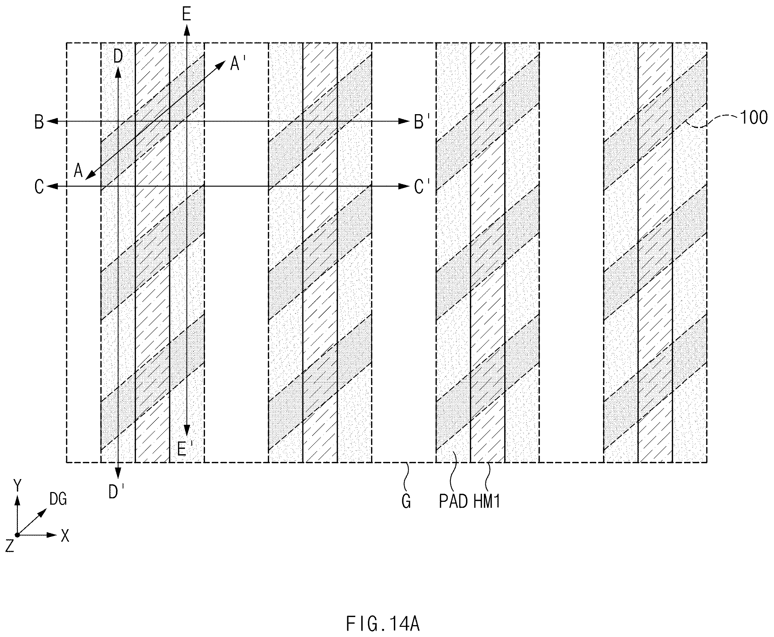

The following embodiments of FIGS. 14A to 14F will hereinafter be described with a focus on the characteristics that are different from those of FIGS. 13A to 13F.

FIG. 14A is a plan view illustrating a result of performing operation S50 of FIG. 9 based on an embodiment of the present disclosure.

Referring to FIGS. 2, 3, 9, and 14A to 14F, the present manufacturing method may include physically isolating (S50) a pad layer (PAD) contacting one side of the open trench (OT) and another pad layer (PAD) contacting the other side of the open trench (OT) from each other by removing a portion formed at the center of the open trench (OT) among the pad layers (PAD).

Referring to FIGS. 13A and 14A, when each pad layer (PAD) is connected between two active regions 100 that are spaced apart from each other, the two active regions 100 that should be electrically isolated from each other are electrically connected to each other, so that a portion formed at the center of the open trench (OT) among the pad layers (PAD) needs to be removed. When a portion of the pad layer (PAD) is removed between two active regions 100 that are adjacent to each other in the first direction (X), a gap region (G) is formed. Although FIG. 14A illustrates that the gap region (G) extends to the ends of the active regions 100 that are spaced apart from each other in the first direction (X), however, the embodiments of the present disclosure are not limited thereto, and the gap region (G) may have a narrower width in the first direction (X). The width of the gap region (G) in the first direction may be wider than the width of the remaining pad region (PAD) in the first direction. In the present disclosure, for convenience of description, an embodiment in which the gap region (G) is formed to extend to the ends of the two active regions 100 adjacent to each other in the first direction (X) will be described. The gap region (G) may extend in the second direction (Y).

FIG. 14A is a plan view illustrating a result of performing operation S50 of FIG. 9 based on an embodiment of the present disclosure.

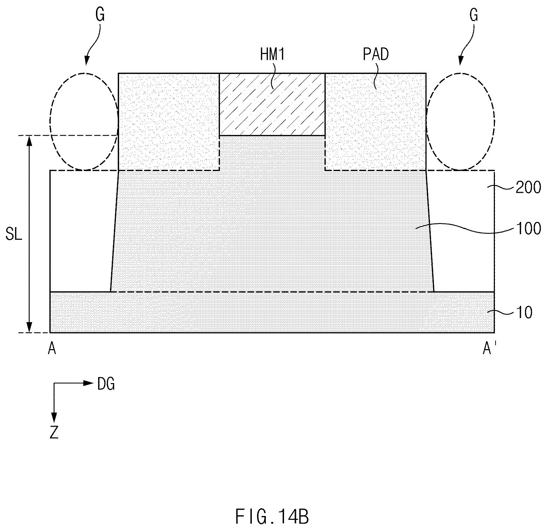

Referring to FIGS. 13A, 14A, and 14B, the remaining pad layers (PADs) obtained after the etching process of the pad layer (PAD) is performed in operation S50 may be disposed on both ends of the active region 100, respectively. The pad layer (PAD) may contact the side surfaces of the first pad insulation layer (HM1).

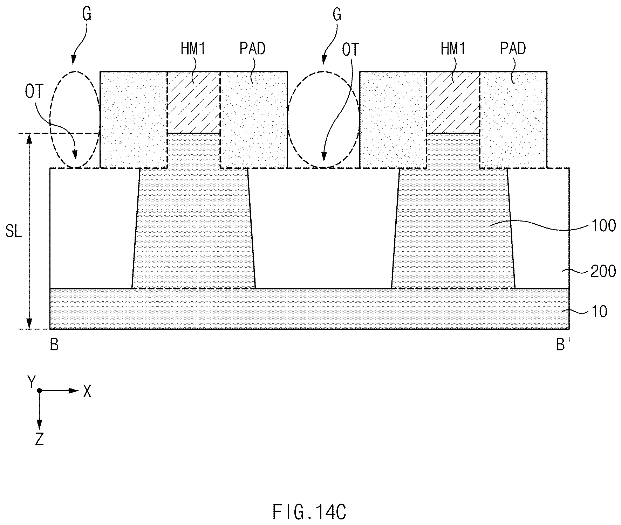

FIG. 14C is a cross-sectional view illustrating a structure of the semiconductor device 1 taken along the line B-B' of FIG. 14A based on an embodiment of the present disclosure.

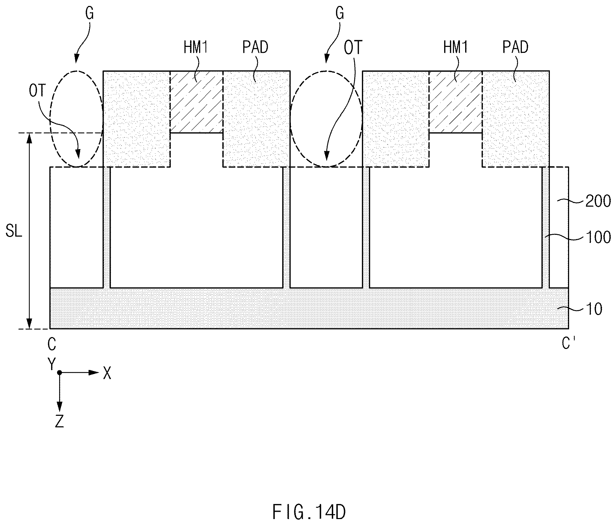

FIG. 14D is a cross-sectional view illustrating a structure of the semiconductor device 1 taken along the line C-C' of FIG. 14A based on an embodiment of the present disclosure.

Referring to FIGS. 13A, 14A, 14C, and 14D, one or more gap regions (G) may be repeatedly arranged spaced apart from each other in the first direction (X). Each of the gap regions (G) may be located at the center of a corresponding one of the open trenches (OT). In the two adjacent active regions 100 of FIG. 14C, a pad layer (PAD) contacting the right end of the left active region 100 and a pad layer (PAD) contacting the left end of the right active region 100 may be physically isolated from each other. In operation S50, the pad layer (PAD) etching process may be performed to an extent that the pad layer (PAD) disposed at the center of the open trench (OT) is completely removed.

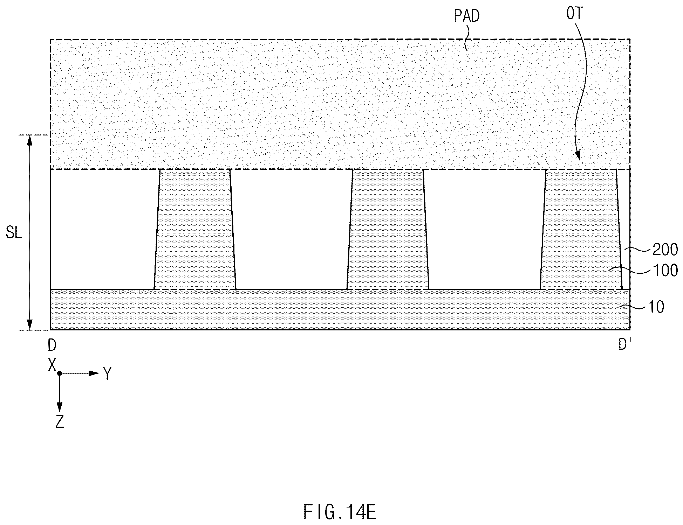

FIG. 14E is a cross-sectional view illustrating a structure of the semiconductor device 1 taken along the line D-D' of FIG. 14A based on an embodiment of the present disclosure.

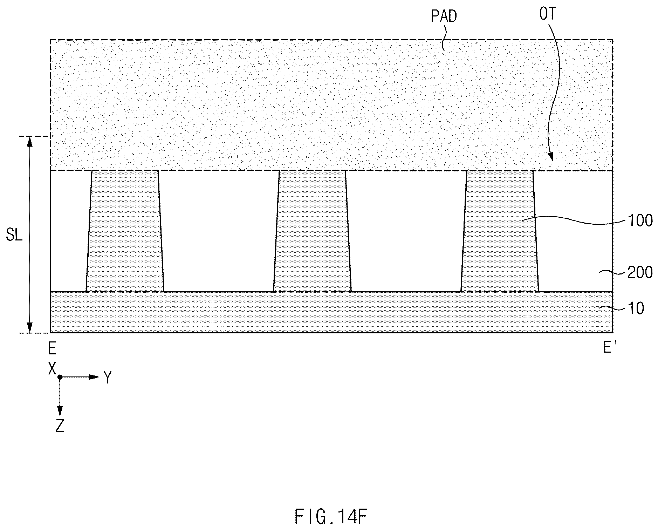

FIG. 14F is a cross-sectional view illustrating a structure of the semiconductor device 1 taken along the line E-E' of FIG. 14A based on an embodiment of the present disclosure.

The cross-section of FIG. 14E may be substantially the same as the cross-section of FIG. 13E. The cross-section of FIG. 14F may be substantially the same as the cross-section of FIG. 13F.

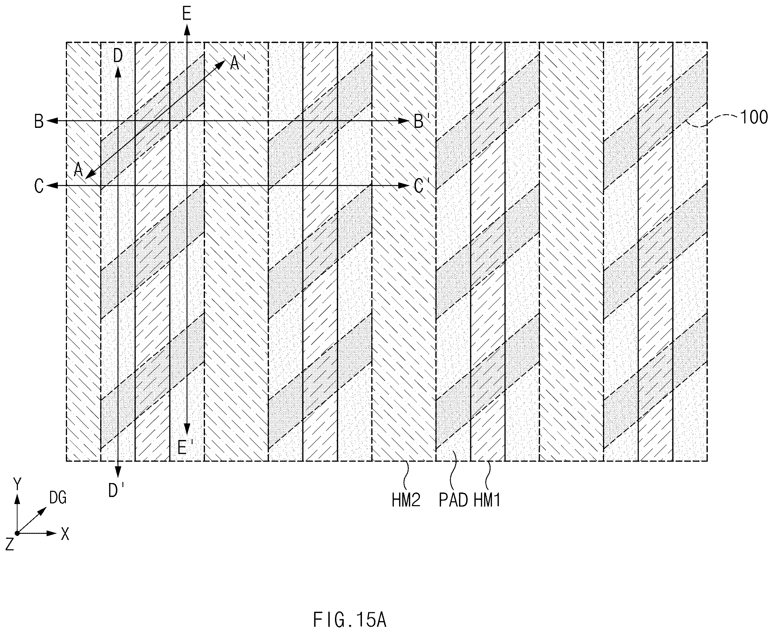

The following embodiments of FIGS. 15A to 15F will hereinafter be described with a focus on the characteristics that are different from those of FIGS. 14A to 14F.

FIG. 15A is a plan view illustrating a result of performing operation S60 of FIG. 9 based on an embodiment of the present disclosure.

Referring to FIGS. 2, 3, 9, and 15A to 15F, the present manufacturing method may include forming (S60) a second pad insulation layer (HM2) that gap-fills the gap region (G) located at the center of the open trench (OT).

Referring to FIGS. 14A and 15A, the second pad insulation layer (HM2) gap-filling the gap region (G of FIG. 14A) with an insulation material may be formed. The second pad insulation layer (HM2) may extend in the second direction (Y). The plurality of the second pad insulation layers (HM2) may be arranged repeatedly spaced apart from each other in the first direction (X).

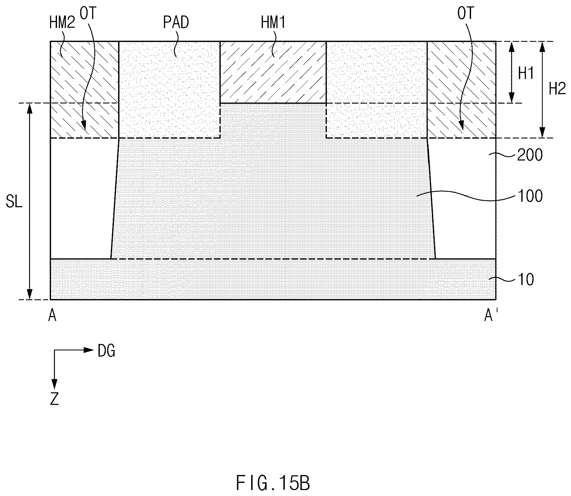

FIG. 15B is a cross-sectional view illustrating a structure of the semiconductor device 1 taken along the line A-A' of FIG. 15A based on an embodiment of the present disclosure.

Referring to FIGS. 14A, 15A, and 15B, the second pad insulation layer (HM2) may be formed on the side surface of the pad layer (PAD). After forming the second pad insulation layer (HM2), a planarization process may be additionally performed. The first pad insulation layer (HM1) may have a first height (H1). The first pad insulation layer (HM1) may be disposed on the top surface of the semiconductor layer (SL). The bottom surface of the first pad insulation layer (HM1) may be located at the same plane as the top surface of the semiconductor layer (SL). The second pad insulation layer (HM2) may have a second height (H2). The second height (H2) may be higher than the first height (H1). The bottom surface of the second pad insulation layer (HM2) may be located at the same plane as the bottom surface of the open trench (OT). The top surface of the first pad insulation layer (HM1) and the top surface of the second pad insulation layer (HM2) may be located at the same plane. The top surface of the pad layer (PAD) may also be located at the same plane as the top surfaces of the first pad insulation layer (HM1) and the second pad insulation layer (HM2).

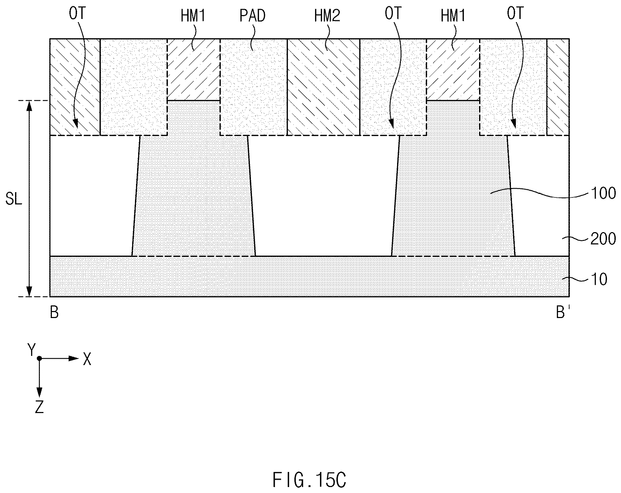

FIG. 15C is a cross-sectional view illustrating a structure of the semiconductor device 1 taken along the line B-B' of FIG. 15A based on an embodiment of the present disclosure.

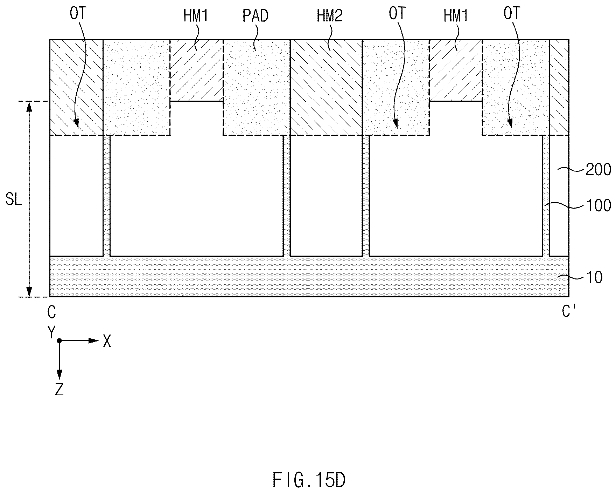

FIG. 15D is a cross-sectional view illustrating a structure of the semiconductor device 1 taken along the line C-C' of FIG. 15A based on an embodiment of the present disclosure.

Referring to FIGS. 14A, 15A, 15C, and 15D, the second pad insulation layer (HM2) may be arranged in a space between two pad layers (PADs) spaced apart from each other in the first direction (X) within each open trench (OT). The plurality of the second pad insulation layers (HM2) may be repeatedly formed spaced apart from each other in the first direction (X). The second pad insulation layer (HM2) may be formed over the cell isolation region 200.

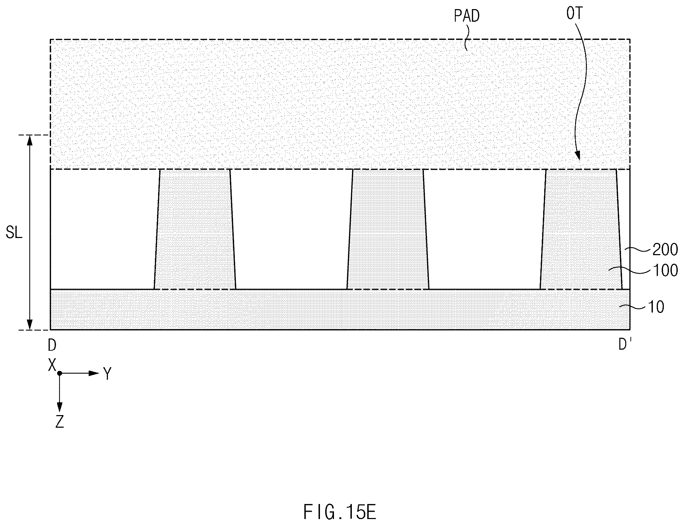

FIG. 15E is a cross-sectional view illustrating a structure of the semiconductor device 1 taken along the line D-D' of FIG. 15A based on an embodiment of the present disclosure.

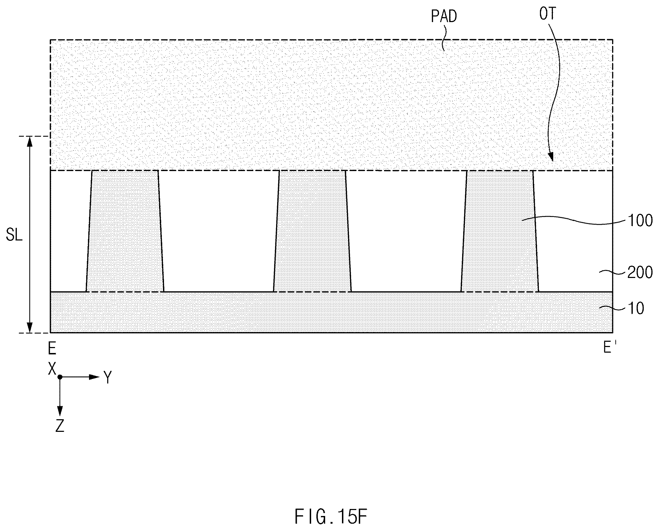

FIG. 15F is a cross-sectional view illustrating a structure of the semiconductor device 1 taken along the line E-E' of FIG. 15A based on an embodiment of the present disclosure.

The cross-section of FIG. 15E may be substantially the same as the cross-section of FIG. 14E. The cross-section of FIG. 15F may be substantially the same as the cross-section of FIG. 14F.

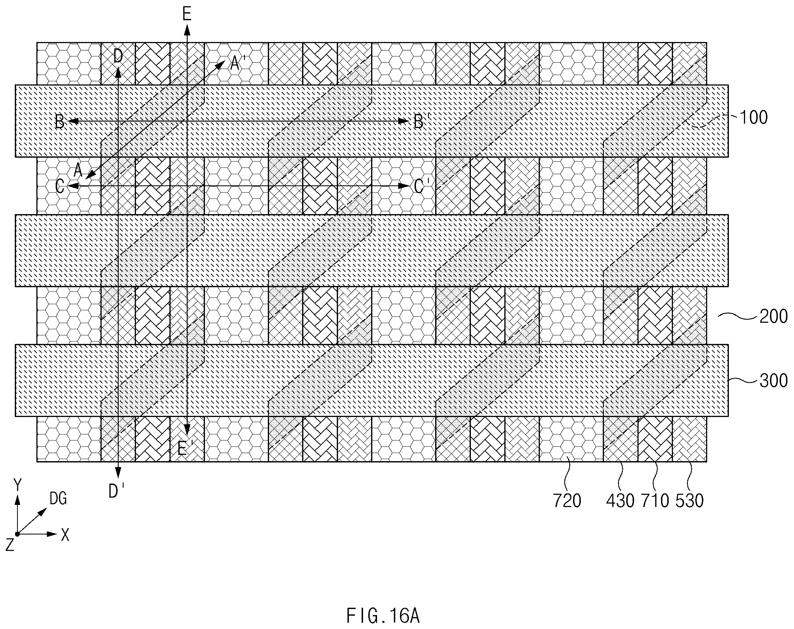

The following embodiments of FIGS. 16A to 16F will hereinafter be described with a focus on the characteristics that are different from those of FIGS. 15A to 15F.

FIG. 16A is a plan view illustrating a result of performing operation S70 of FIG. 9 based on an embodiment of the present disclosure.

Referring to FIGS. 2, 3, 9, and 16A to 16F, the present manufacturing method may include forming (S70) the plurality of the word-line structures 300.

Referring to FIGS. 9, 10A, and 16A, the word-line structure 300 may be formed to extend in the first direction (X). The word-line structure 300 may be formed by penetrating the pad layer (PAD). The word-line structure 300 may cut (sever) a portion of the pad layers (PADs). In the present disclosure, a portion of the pad layer (PAD) that remains after being cut may be defined as a bit-line pad region 430, and another portion of the pad layer (PAD) that remains after being cut may be defined as a storage-node pad region 530. The word-line structure 300 may be formed by penetrating the first pad insulation layer (HM1) and the second pad insulation layer (HM2). The word-line structure 300 may cut (or sever) a portion of the first pad insulation layer (HM1) and a portion of the second pad insulation layer (HM2). The first pad insulation layer (HM1) that remains after being cut may be defined as a first pad insulation region 710. The second pad insulation layer (HM2) that remains after being cut may be defined as a second pad insulation region 720.

The plurality of the first pad insulation regions 710 may be repeatedly arranged spaced apart from each other in the second direction (Y). Each of the plurality of the first pad insulation regions 710 may be disposed between word-line structures 300 adjacent to each other in the second direction (Y). One side (e.g., the left side in FIG. 16A) of each of the plurality of the first pad insulation regions 710 may contact the bit-line pad region 430. The other side (e.g., the right side in FIG. 16A) of each of the plurality of the first pad insulation regions 710 may contact the storage-node pad region 530.

The plurality of the second pad insulation regions 720 may be repeatedly arranged spaced apart from each other in the second direction (Y). Each of the plurality of the second pad insulation regions 720 may be disposed between word-line structures 300 adjacent to each other in the second direction (Y). One side (e.g., the left side in FIG. 16A) of each of the plurality of the second pad insulation regions 720 may contact the storage-node pad region 530. The other side (e.g., the right side in FIG. 16A) of each of the plurality of the second pad insulation regions 720 may contact the bit-line pad region 430.

The plurality of the bit-line pad regions 430 may overlap one end of the active region 100. The plurality of the bit-line pad regions 430 may be repeatedly arranged spaced apart from each other in the second direction (Y). The plurality of the bit-line pad regions 430 may be disposed between word-line structures 300 adjacent to each other in the second direction (Y). One side (e.g., the left side in FIG. 16A) of each of the plurality of the bit-line pad regions 430 may contact the second pad insulation region 720. The other side (e.g., the right side in FIG. 16A) of each of the plurality of the bit-line pad regions 430 may contact the first pad insulation region 710.

The plurality of the storage-node pad regions 530 may overlap with the other end of the active region 100. The plurality of the storage-node pad regions 530 may be repeatedly arranged spaced apart from each other in the second direction (Y). The plurality of the storage-node pad regions 530 may be disposed between word-line structures 300 adjacent to each other in the second direction (Y). One side (e.g., the left side in FIG. 16A) of each of the plurality of the storage-node pad regions 530 may contact the first pad insulation region 710. The other side (e.g., the right side in FIG. 16A) of each of the plurality of the storage-node pad regions 530 may contact the second pad insulation region 720.

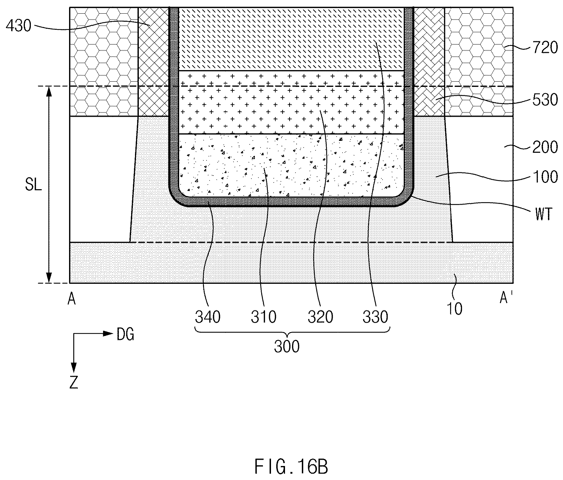

FIG. 16B is a cross-sectional view illustrating a structure of the semiconductor device 1 taken along the line A-A' of FIG. 16A based on an embodiment of the present disclosure.

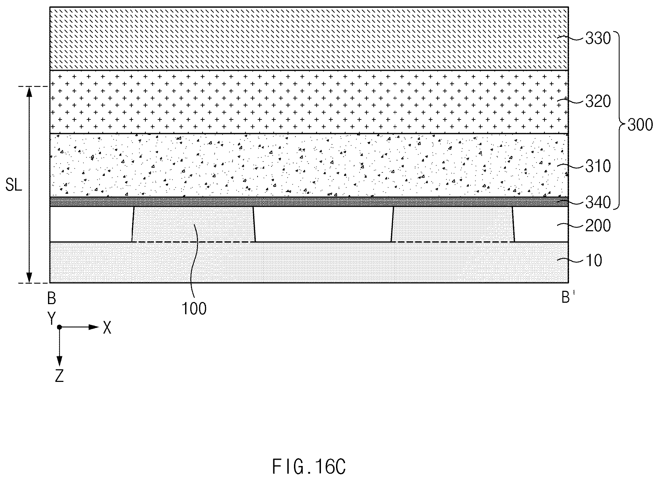

FIG. 16C is a cross-sectional view illustrating a structure of the semiconductor device 1 taken along the line B-B' of FIG. 16A based on an embodiment of the present disclosure.

Referring to FIGS. 15A, 16A, 16B, and 16C, a word-line trench (WT) may be formed to extend in a third direction (Z) from a plane where the top surface of the bit-line pad region 430 and the top surface of the storage-node pad region 530 are located. The word-line trench (WT) may have a greater recessed depth in the third direction (Z) from the top surface of the semiconductor layer (SL) than the open trench (OT) shown in FIG. 12B or the like. After the word-line trench (WT) is formed, a word-line insulation layer 340 that contacts the bottom and side surfaces of the word-line trench (WT) and extends in the first direction (X) may be formed. Thereafter, a first word-line electrode layer 310 extending in the first direction (X) may be formed on the word-line insulation layer 340. Thereafter, a second word-line electrode layer 320 extending in the first direction (X) may be formed on the first word-line electrode layer 310.

As illustrated in FIGS. 16B and 16C, an embodiment in which the top surface of the semiconductor layer (SL) is located higher than the top surface of the first word-line electrode layer 310 and lower than the top surface of the second word-line electrode layer 320 is illustrated, but the embodiments of the present disclosure are not limited thereto. For example, the top surface of the second word-line electrode layer 320 may also be located lower than the top surface of the semiconductor layer (SL).

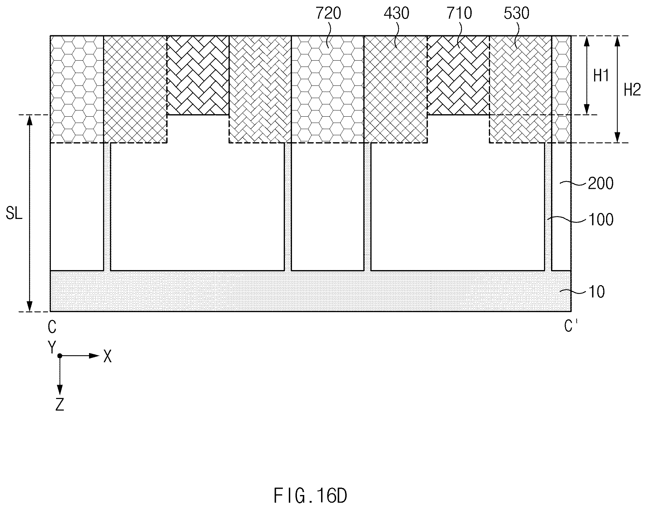

FIG. 16D is a cross-sectional view illustrating a structure of the semiconductor device 1 taken along the line C-C' of FIG. 16A based on an embodiment of the present disclosure.

Referring to FIGS. 15A, 15D, 16A, and 16D, FIG. 16D may be substantially the same cross-section as FIG. 15D. A first pad insulation region 710 may be disposed on the top surface of the semiconductor layer (SL) to contact the cell isolation region 200. The bit-line pad region 430 may be disposed to contact one side (e.g., the left side in FIG. 16D) of the first pad insulation region 710. The storage-node pad region 530 may be disposed to contact the other side (e.g., the right side in FIG. 16D) of the first pad insulation region 710. A second pad insulation region 720 may be disposed to contact one side (e.g., the left side in FIG. 16D) of the bit-line pad region 430. The second pad insulation region 720 may be disposed to contact one side (e.g., the right side in FIG. 16D) of the storage-node pad region 530.

The first pad insulation region 710 may have a first height (H1). Each of the second pad insulation region 720, the bit-line pad region 430, and the storage-node pad region 530 may have a second height (H2). The second height (H2) may be higher than the first height (H1).

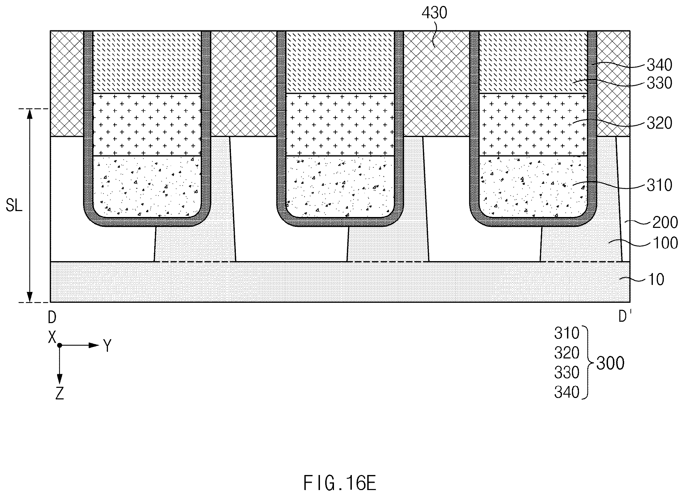

FIG. 16E is a cross-sectional view illustrating a structure of the semiconductor device 1 taken along the line D-D' of FIG. 16A based on an embodiment of the present disclosure.

Referring to FIGS. 15A, 16A, and 16E, the plurality of the word-line structures 300 may be repeatedly arranged spaced apart from each other in the second direction (Y). One side of the word-line structure 300 may contact the bit-line pad region 430 that is in contact with the active region 100 contacting the bottom and side surfaces of the word-line structure 300.

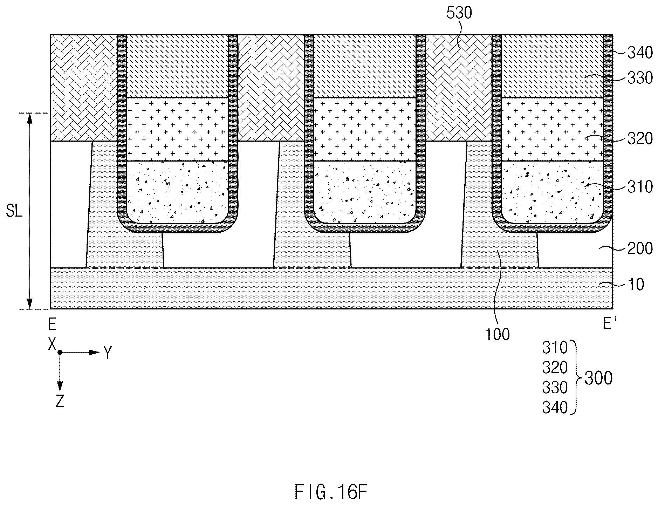

FIG. 16F is a cross-sectional view illustrating a structure of the semiconductor device 1 taken along the line E-E' of FIG. 16A based on an embodiment of the present disclosure.

Referring to FIGS. 15A, 16A, and 16F, the plurality of the word-line structures 300 may be repeatedly arranged spaced apart from each other in the second direction (Y). One side of the word-line structure 300 may contact the storage-node pad region 530 that contacts the active region 100 contacting the bottom and side surfaces of the word-line structure 300.

Referring to FIGS. 12A and 16A, upon formation of the open trenches (OTs) not only for a portion where the bit-line pad region 430 is to be formed, but also for another portion where the storage-node pad region 530 is to be formed, each of the trenches that can be formed is reduced in width. In addition, when considering a minimum pitch that can be processed, the etching process should be performed several times, which may cause unexpected problems such as an increase in production costs and an increase in the number of process steps. However, when the pad trenches (PTs) are formed across a portion of each of two adjacent active regions 100 as shown in FIG. 12A to simultaneously form the pad layers (PADs), there is no concern about reaching limitations of the fabrication technology, and the etching process can be performed only once, resulting in reduction in production costs. In addition, even if the pad layer (PAD) is formed to extend in the second direction (Y), when forming the word-line structure 300, the bit-line pad regions 430 between adjacent active regions 100 are electrically and physically isolated from each other, and the storage-node pad regions 530 between adjacent active regions 100 are also electrically and physically isolated from each other, so that the manufacturing process can be simplified.

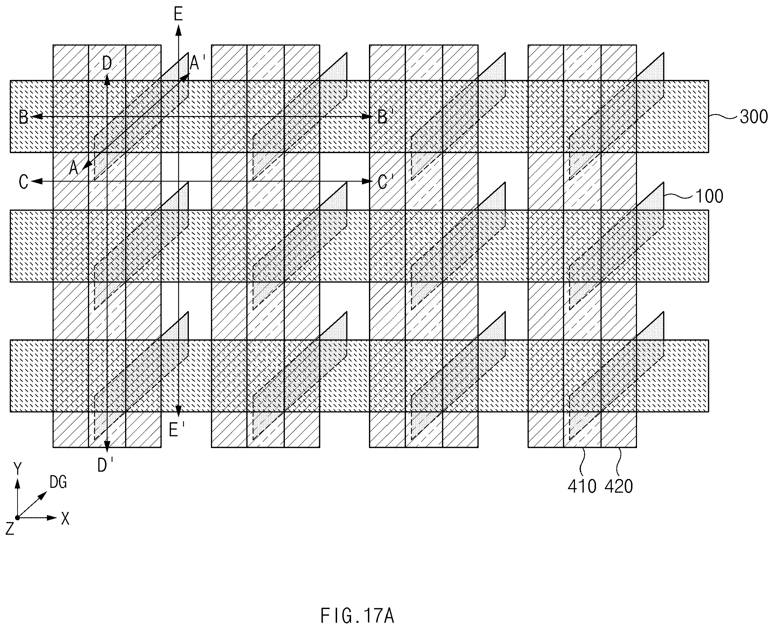

The following embodiments of FIGS. 17A to 17F will hereinafter be described with a focus on the characteristics that are different from those of FIGS. 16A to 16F.

FIG. 17A is a plan view illustrating a result of performing operation S80 of FIG. 9 based on an embodiment of the present disclosure.

Referring to FIGS. 2, 3, 9, and 17A to 17F, the present manufacturing method may include forming (S80) the plurality of bit-line electrode layers 410, the plurality of the bit-line spacers 420, the plurality of bit-line contact regions 440, and the plurality of bit-line capping layers 450.

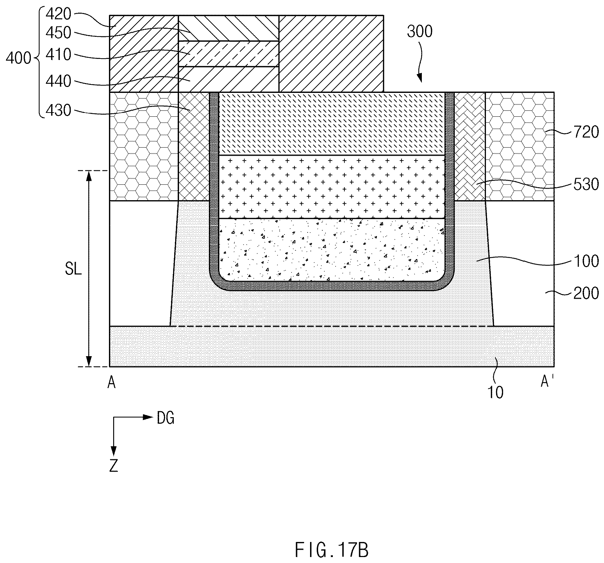

FIG. 17B is a cross-sectional view illustrating a structure of the semiconductor device 1 taken along the line A-A' of FIG. 17A based on an embodiment of the present disclosure.

Referring to FIGS. 9, 10A, 17A, and 17B, the bit-line contact region 440 may be formed to contact the top surface of the bit-line pad region 430. Thereafter, the bit-line electrode layer 410 disposed on the bit-line contact region 440 may be formed. The bit-line electrode layer 410 may be formed to extend in the second direction (Y). Thereafter, the bit-line capping layer 450 disposed on the bit-line electrode layer 410 may be formed. The bit-line spacers 420 may be formed to contact both sides of each of the bit-line electrode layer 410, the bit-line contact region 440, and the bit-line capping layer 450.

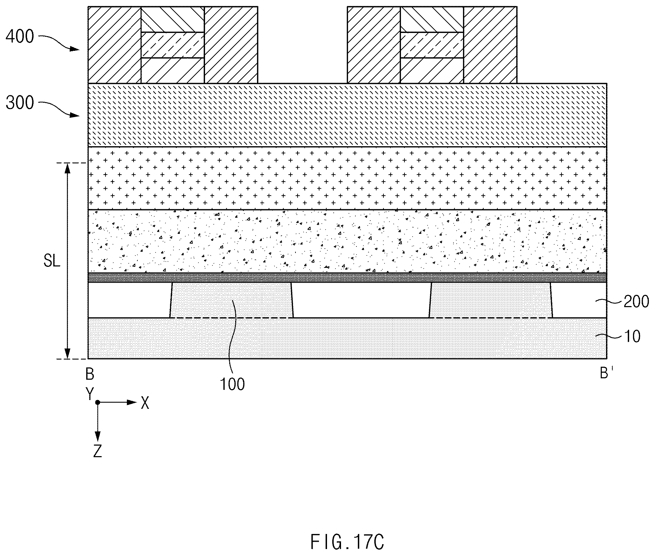

FIG. 17C is a cross-sectional view illustrating a structure of the semiconductor device 1 taken along the line B-B' of FIG. 17A based on an embodiment of the present disclosure.

Referring to FIGS. 9, 10A, 17A, and 17C, the plurality of bit-line contact regions 440 may be formed spaced apart from each other in the first direction (X). The plurality of bit-line electrode layers 410 may be formed spaced apart from each other in the first direction (X). The plurality of bit-line capping layers 450 may be formed spaced apart from each other in the first direction (X). The plurality of the bit-line spacers 420 may laterally contact the bit-line electrode layer 410 in the first direction (X), and may laterally contact the bit-line electrode layer 410 in a direction opposite to the first direction (X).

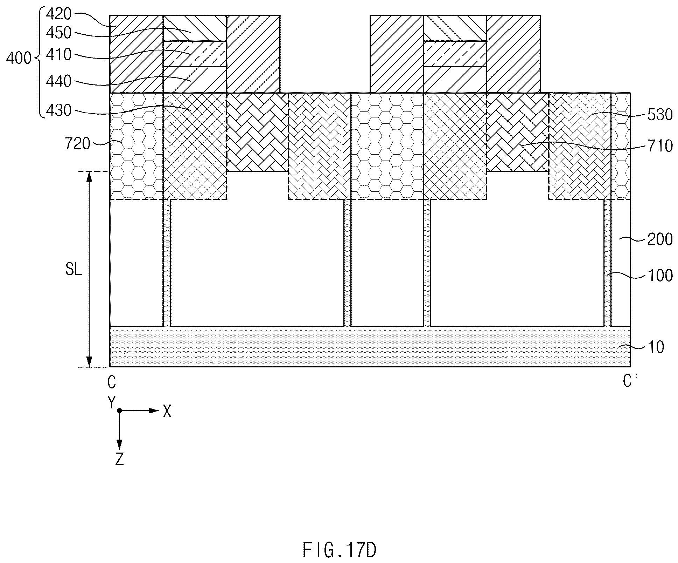

FIG. 17D is a cross-sectional view illustrating a structure of the semiconductor device 1 taken along the line C-C' of FIG. 17A based on an embodiment of the present disclosure.

Referring to FIGS. 9, 10A, 17A, and 17D, a portion of the bit-line spacer 420 may be disposed on the first pad insulation region 710. Another portion of the bit-line spacer 420 may be disposed on the second pad insulation region 720.

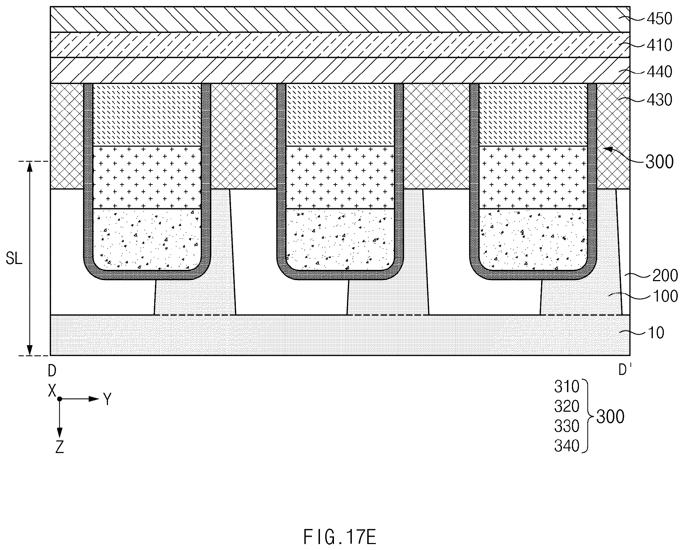

FIG. 17E is a cross-sectional view illustrating a structure of the semiconductor device 1 taken along the line D-D' of FIG. 17A based on an embodiment of the present disclosure.

Referring to FIGS. 9, 10A, 17A, and 17E, each of the bit-line contact region 440, the bit-line electrode layer 410, the bit-line capping layer 450, and the bit-line spacer 420 may be formed to extend in the second direction (Y).

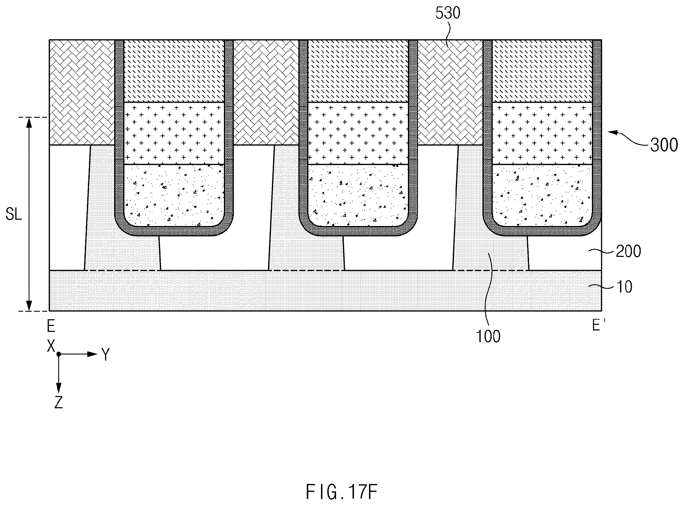

FIG. 17F is a cross-sectional view illustrating a structure of the semiconductor device 1 taken along the line E-E' of FIG. 17A based on an embodiment of the present disclosure.

FIG. 17F may be substantially the same cross-section as FIG. 16F.

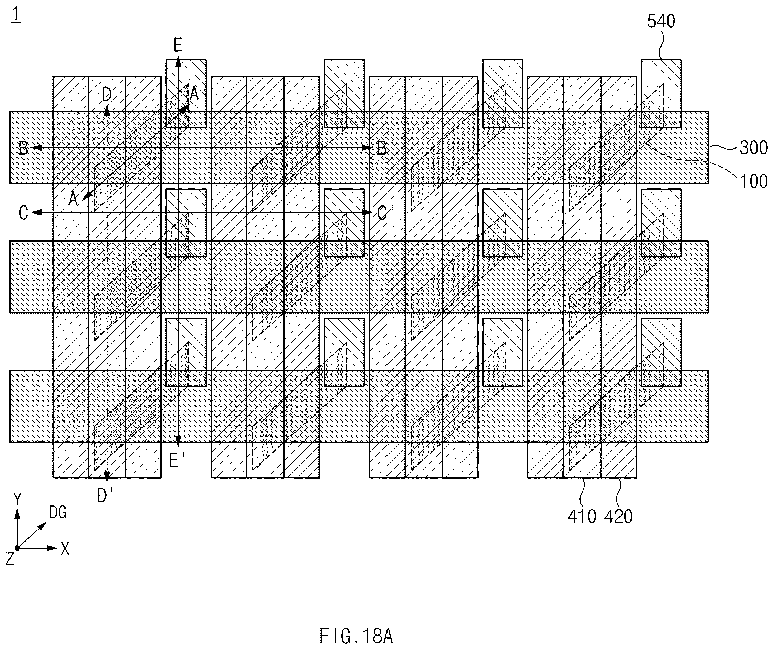

The following embodiments of FIGS. 18A to 18F will hereinafter be described with a focus on the characteristics that are different from those of FIGS. 17A to 17F.

FIG. 18A is a plan view illustrating a result of performing operation S90 of FIG. 9 based on an embodiment of the present disclosure.

Referring to FIGS. 2, 3, 9, and 18A to 18F, the present manufacturing method may include forming (S90) the plurality of the storage-node contact regions 540.

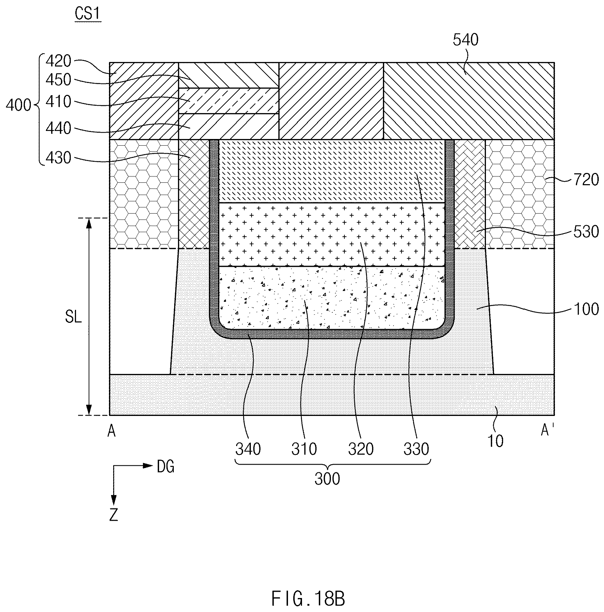

FIG. 18B is a cross-sectional view illustrating a structure of the semiconductor device 1 taken along the line A-A' of FIG. 18A based on an embodiment of the present disclosure.

Referring to FIGS. 9, 10A, 18A, and 18B, each of the plurality of the storage-node contact regions 540 may be formed to overlap with some parts of the active regions 100. One end of the active region 100 may be formed to overlap with the bit-line pad region 430. The other end of the active region 100 may be formed to overlap with the storage-node contact regions 540. Each of the storage-node contact regions 540 may contact the top surface of the storage-node pad region 530. Each of the storage-node contact regions 540 may contact the top surface of the second pad insulation region 720.

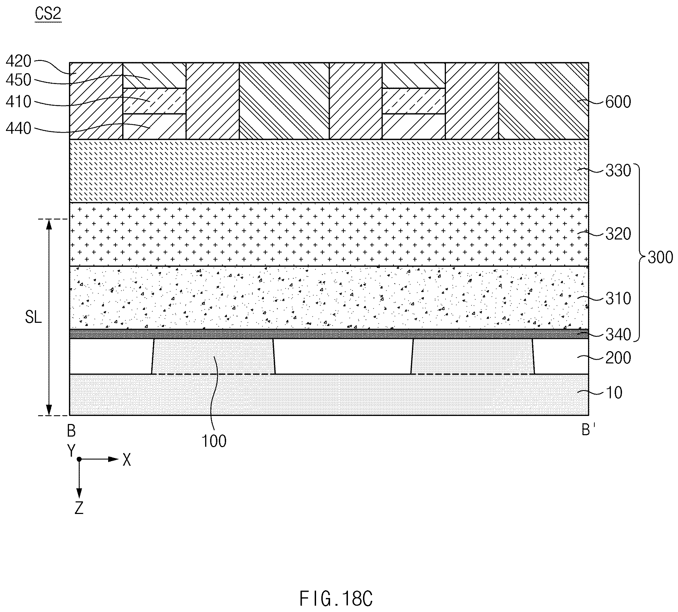

FIG. 18C is a cross-sectional view illustrating a structure of the semiconductor device 1 taken along the line B-B' of FIG. 18A based on an embodiment of the present disclosure.

Referring to FIG. 18C, the plurality of contact insulation regions 600 may be disposed between the bit-line spacers 420. For example, the contact insulation regions 600 may contact the bit-line spacers 420 in the first direction (X). The contact insulation regions 600 may contact the bit-line spacers 420 in a direction opposite to the first direction (X).

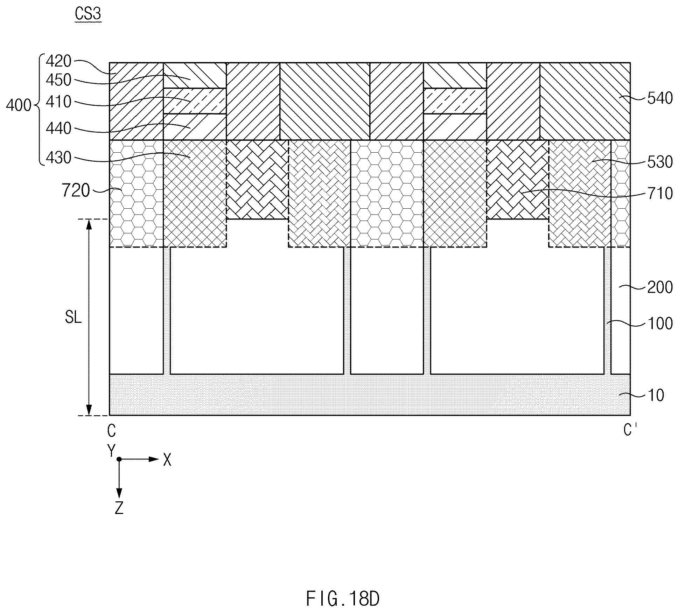

FIG. 18D is a cross-sectional view illustrating a structure of the semiconductor device taken along the line C-C' of FIG. 18A based on an embodiment of the present disclosure.

Referring to FIG. 18D, the plurality of the storage-node contact regions 540 may be disposed between the bit-line spacers 420. For example, the storage-node contact regions 540 may contact the bit-line spacers 420 in the first direction (X). The storage-node contact regions 540 may contact the bit-line spacers 420 in a direction opposite to the first direction (X).

Referring to FIGS. 10, 15B, and 18D, as the depth at which the cell isolation region 200 is formed increases, the process of forming the cell isolation region 200 becomes complicated. As the first pad insulation region 710 and the second pad insulation region 720 are formed to a position higher than the surface of the semiconductor layer (SL), the top surface of each of the first pad insulation region 710 and the second pad insulation region 720 and the surface of the semiconductor layer (SL) may be spaced apart from each other by a first height (H1).

Compared to the embodiment in which the first pad insulation region 710 and the second pad insulation region 720 are absent, the embodiments in which the first pad insulation region 710 and the second pad insulation region 720 are present may have the same effect as if the cell isolation region 200 were formed at the same depth as the pad insulation regions (710, 720) even though the cell isolation region 200 is formed less deep by the first height (H1). As a result, since the semiconductor device 1 according to the embodiments of the present disclosure is configured such that the cell isolation region 200 can be formed at a relatively less deep position, a process burden of the semiconductor device 1 can be reduced.

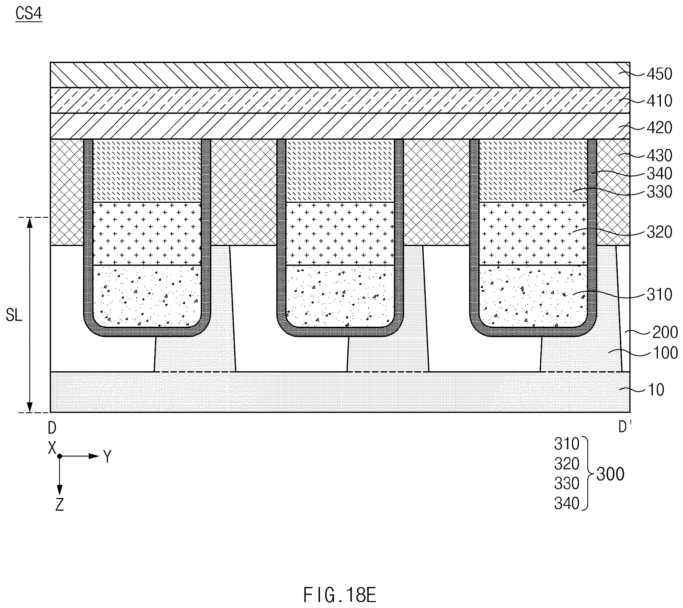

FIG. 18E is a cross-sectional view illustrating a structure of the semiconductor device 1 taken along the line D-D' of FIG. 18A based on an embodiment of the present disclosure.

FIG. 18E may be substantially the same cross-section as FIG. 17E.

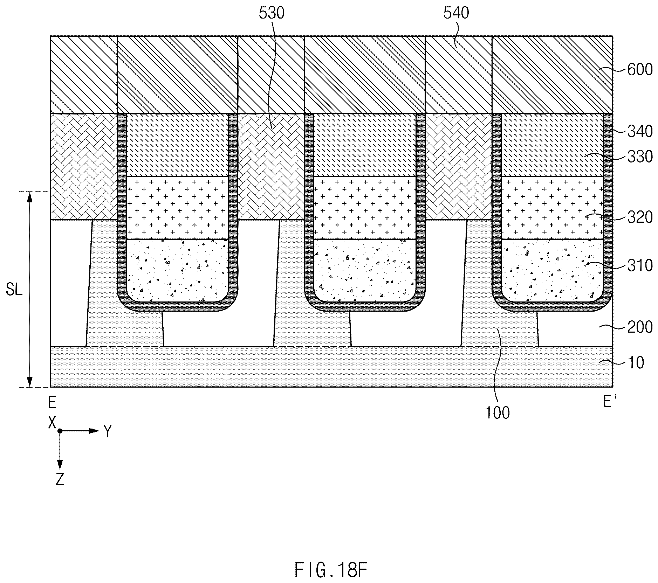

FIG. 18F is a cross-sectional view illustrating a structure of the semiconductor device 1 taken along the line E-E' of FIG. 18A based on an embodiment of the present disclosure.

Referring to FIG. 18F, the plurality of the storage-node contact regions 540 and the plurality of contact insulation regions 600 may be alternately and repeatedly formed in the second direction (Y). Two side surfaces of each of the plurality of the storage-node contact regions 540 may contact the contact insulation region 600. Two side surfaces of each of the plurality of contact insulation regions 600 may contact the storage-node contact regions 540. For example, the storage-node contact regions 540 may contact the contact insulation regions 600 in the second direction (Y). The storage-node contact regions 540 may contact the contact insulation regions 600 in a direction opposite to the second direction (Y). In addition, the contact insulation regions 600 may contact the storage-node contact regions 540 in the second direction (Y). The contact insulation regions 600 may contact the storage-node contact regions 540 in a direction opposite to the second direction (Y).

FIG. 19 is a plan view illustrating a portion of a semiconductor device 1 when the word-line structure 300 or the bit-line structure 400 shown in FIG. 3 is misaligned.

According to the embodiment in which the first pad insulation region 710 and the second pad insulation region 720 are absent, the bottom surface of the bit-line contact region 440 and the bottom surface of the storage-node contact region 540 may be located at the same plane as the top surface of the semiconductor layer (SL). In this case, if the word-line structure 300 or the bit-line structure 400 is formed in a misaligned manner, a bridge phenomenon may occur between the storage-node contact region 540 corresponding to the active region (100-2) and a portion of the active region (100-1) in which the bit-line contact region 440 of the active region (100-1) is formed, so that electrical interaction may occur between different unit cells (UCs), and the area in which the bit-line contact region 440 or the storage-node contact region 540 in the active region 100 may be formed may decrease, and the reliability of the semiconductor device 1 may deteriorate.

The active region (100-1) and the active region (100-2) of FIG. 19 may mean the active regions 100 adjacent to each other in FIGS. 2 and 3. For example, the active region (100-2) may mean any active region 100 among the plurality of the active regions 100. The active region (100-1) may mean the active region 100 adjacent to the active region (100-2). The active region (100-1) may be an active region 100 spaced apart from the active region (100-2) in the second direction (Y).

However, according to the embodiments of the present disclosure, the top surface of the semiconductor layer (SL) is spaced apart from the bottom surfaces of the bit-line contact region 440 and the storage-node contact region 540 by the first height (H1) which is the height of the first pad insulation region 710. As a result, even when the word-line structure 300 or the bit-line structure 400 is formed in a misaligned manner, the bridge phenomenon in which electrical interaction occurs between adjacent unit cells (UC) may be prevented.

Referring to FIGS. 18A to 18F and FIG. 19, the portions denoted by dotted lines in FIG. 19 may refer to the positions of the word-line structure 300 and the bit-line electrode layer 410 that are exactly aligned. A first misaligned bit-line electrode layer (410-L) may refer to a bit-line electrode layer formed to be biased (offset) to the left (i.e., in a direction opposite to the first direction X). A second misaligned bit-line electrode layer (410-R) may refer to a bit-line electrode layer formed to be biased (offset) to the right (i.e., in the first direction X). A first misaligned word-line structure (300-U) may refer to a word-line structure formed to be biased (offset) upward (i.e., in the second direction Y) in the drawing. The second misaligned word-line structure (300-D) may refer to a word-line structure formed to be biased (offset) downward (i.e., in a direction opposite to the second direction Y) in the drawing.

In a situation where the word-line structure 300 is biased in the second direction (Y), a region that is located at one end of the first misaligned word-line structure (300-U) and overlaps with the bit-line pad region 430 is referred to as a first region (100A), a distance (W1) between the first region (100A) and the storage-node contact region (540A) of the active region 100 adjacent in a direction opposite to the second direction (Y) becomes shorter when viewed in the third direction (Z). However, the bit-line pad region 430 and the storage-node contact region (540A) may be spaced apart from each other not only in the horizontal direction but also in the vertical direction by the first pad insulation region 710 (see FIG. 18D), and electrical interaction between the storage-node contact region (540A) and the first region (100A) may be prevented.

In a situation where the word-line structure 300 is biased in the direction opposite to the second direction (Y), a region that is located at one end of the second misaligned word-line structure (300-D) and overlaps with the storage-node pad region 530 is referred to as a second region (100B), a distance (W2) between the second region (100B) and the bit-line pad region (430B) of the active region 100 adjacent in the second direction (Y) becomes shorter when viewed in the third direction (Z). However, the bit-line pad region (430B) and the storage-node contact region 540 may be spaced apart from each other not only in the horizontal direction but also in the vertical direction by the first pad insulation region 710 (see FIG. 18D), and electrical interaction between the second region (100B) and the bit-line pad region (430B) may be prevented.

In a situation where the bit-line electrode layer 410 is biased in the first direction (X), a region that is located at one end of the first misaligned bit-line electrode layer (410-L) and overlaps with the storage-node pad region 530 is referred to as a third region (100C), a distance (W3) between the third region (100C) and the bit-line pad region (430C) of the active region 100 adjacent in the second direction (Y) becomes shorter when viewed in the third direction (Z). However, the bit-line pad region (430C) and the storage-node contact region 540 may be spaced apart from each other not only in the horizontal direction but also in the vertical direction by the first pad insulation region 710 (see FIG. 18D), and electrical interaction between the third region (100C) and the bit-line pad region (430C) may be prevented.

In a situation where the bit-line electrode layer 410 is biased in the direction opposite to the first direction (X), a region that is located at one end of the second misaligned bit-line electrode layer (410-R) and overlaps with the bit-line pad region 430 is referred to as a fourth region (100D), a distance (W4) between the fourth region (100D) and the storage-node contact region (540D) of the active region 100 adjacent in the second direction (Y) becomes shorter when viewed in the third direction (Z). However, the bit-line pad region (430B) and the storage-node contact region 540 may be spaced apart from each other not only in the horizontal direction but also in the vertical direction by the first pad insulation region 710 (see FIG. 18D), and electrical interaction between the fourth region (100D) and the storage-node contact region (540D) may be prevented.

In addition, according to the embodiments of the present disclosure, even when the open trench (OT) is formed to be slightly biased in the first direction (X) or in the opposite direction to the first direction (X) in operation S30 of FIG. 9, electrical interaction between the bit-line pad region 430 and the storage-node contact region 540 adjacent to each other is prevented by the first pad insulation region 710, so that reliability of the semiconductor device 1 can be improved.

As is apparent from the above description, the semiconductor device based on an embodiment of the present disclosure can facilitate a fabrication process of bit-line contacts and storage-node contacts, thereby securing necessary resistance. In addition, the semiconductor device based on an embodiment of the present disclosure includes a pad region disposed between the bit-line contact and the active region, and another pad region disposed between the storage-node contact and the active region, resulting in reduction in contact resistance. In addition, the semiconductor device based on an embodiment of the present disclosure is configured such that a predetermined pad region and pad insulation regions are formed to be higher than a surface of the active region so that a cell isolation region can have a smaller depth, thereby reducing fabrication difficulty in a patterning process of the active regions.

In addition, the method for manufacturing the semiconductor device based on an embodiment of the present disclosure can reduce production costs of the semiconductor device, and can simplify the fabrication process (i.e., can reduce the number of fabrication steps) of the semiconductor device.

The embodiments of the present disclosure may provide a variety of advantageous effects capable of being directly or indirectly recognized by one of ordinary skill in the art.

Those skilled in the art will appreciate that the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments can be devised based on what is described and illustrated in the present disclosure. Furthermore, the embodiments may be combined to form additional embodiments.

## Claims

1. A semiconductor device comprising:
a plurality of word-line structures extending in a first direction, and configured spaced apart from each other in a second direction;
a plurality of active regions extending in a diagonal direction forming an acute angle with the first direction, configured to overlap with the word-line structures, and configured spaced apart from each other in the first direction;
a plurality of bit-line pad regions, each of which overlaps with one end of the active region and contacts one side of the word-line structure;
a plurality of storage-node pad regions, each of which overlaps with another end of the active region and contacts another side of the word-line structure;
a plurality of first pad insulation regions, each of which contacts the bit-line pad region, contacts the one side of the word-line structure, and is formed to have a first height; and
a plurality of second pad insulation regions, each of which contacts the storage-node pad region, contacts the another side of the word-line structure, and is formed to have a second height higher than the first height.

2. The semiconductor device according to claim 1, wherein:
each of the plurality of the bit-line pad regions has a third height from a top surface of the active region;
each of the plurality of the storage-node pad regions has a fourth height from the top surface of the active region; and
each of the third height and the fourth height is equal to the second height.

3. The semiconductor device according to claim 2, wherein
a bottom surface of the bit-line pad region and a bottom surface of the storage-node pad region are located lower than a bottom surface of the first pad insulation region.

4. The semiconductor device according to claim 2, wherein
a bottom surface of the bit-line pad region and a bottom surface of the storage-node pad region are located at a same plane as a bottom surface of the second pad insulation region.

5. The semiconductor device according to claim 1, further comprising:
a plurality of bit-line contact regions, each of which contacts a top surface of the bit-line pad region;
a plurality of storage-node contact regions, each of which contacts a top surface of the storage-node pad region;
a plurality of bit-line electrode layers, each of which is disposed on the bit-line contact region, overlaps with the bit-line pad region, and extends in the second direction; and
a plurality of bit-line spacers, each of which contacts both sides of the bit-line electrode layer and extends in the second direction.

6. The semiconductor device according to claim 1, wherein:
the second direction is perpendicular to the first direction; and
the second direction forms an acute angle with the diagonal direction.

7. The semiconductor device according to claim 1, wherein:
the plurality of the active regions is further arranged spaced apart from each other in the second direction; and
the plurality of the active regions is further arranged spaced apart from each other in the diagonal direction.

8. The semiconductor device according to claim 7, wherein:
each of the plurality of the bit-line pad regions is arranged spaced apart from each other in the second direction; and
each of the plurality of the storage-node pad regions is arranged spaced apart from each other in the second direction.

9. The semiconductor device according to claim 8, wherein:
each of the plurality of the first pad insulation regions contacts a side surface of the bit-line pad region facing the first direction, and each of the plurality of the first pad insulation regions contacts a side surface of the storage-node pad region facing an opposite direction to the first direction;
each of the plurality of the second pad insulation regions contacts a side surface of the bit-line pad region facing the opposite direction to the first direction, and each of the plurality of the second pad insulation regions contacts a side surface of the storage-node pad region facing the first direction;
the plurality of the first pad insulation regions is arranged spaced apart from each other in the second direction; and
the plurality of the second pad insulation regions is arranged spaced apart from each other in the second direction.

10. A method for manufacturing a semiconductor device, the method comprising:
forming a plurality of active regions repeatedly spaced apart from each other in a first direction and a second direction, the plurality of the active regions extends in a diagonal direction with respect to the first direction, and is surrounded by a cell isolation region;
forming a first insulation layer over the plurality of the active regions and the cell isolation region;
forming a plurality of open trenches, each of which is formed by etching a portion of two adjacent active regions and a portion of the first insulation layer;
forming a pad layer that covers not only a plurality of first pad insulation regions remaining after the first insulation layer is etched, but also the plurality of the open trenches;
removing a portion formed at a central portion of each of the open trenches among the pad layer; and
forming a second pad insulation region at the central portion of the open trench.

11. The method according to claim 10, further comprising:
forming a plurality of word-line structures, each of which overlaps with the plurality of the active regions, extends in the first direction, and is repeatedly spaced apart from each other in the second direction.

12. The method according to claim 11, wherein forming the plurality of word-line structures includes:
forming a word-line trench,
wherein the word-line trench is configured to:
cut the plurality of the pad layers that extends in the second direction and is spaced apart from each other in the first direction to form a plurality of bit-line pad regions and a plurality of storage-node pad regions; and
cut the plurality of the first pad insulation regions each extending in the second direction and the plurality of the second pad insulation regions each extending in the second direction,
whereby the word-line trench is recessed into the plurality of the active regions.

13. The method according to claim 12, wherein:
the plurality of the bit-line pad regions is configured to overlap one end of each of the plurality of the active regions; and
the plurality of the storage-node pad regions is configured to overlap another end of each of the plurality of the active regions.

14. The method according to claim 12, wherein forming the plurality of word-line structures further includes:
forming a word-line electrode layer to which an operation signal of the word-line structure is applied;
forming a word-line insulation layer that is formed along an inner wall of the word-line trench and surrounds a bottom surface and side surfaces of the word-line electrode layer; and
forming a word-line capping layer contacting a top surface of the word-line electrode layer.

15. The method according to claim 13, further comprising:
forming a plurality of bit-line contact regions that is respectively disposed on the bit-line pad regions, extends in the second direction, and is spaced apart from each other in the first direction;
forming a plurality of bit-line electrode layers that is respectively disposed on the bit-line contact regions, extends in the second direction, and is spaced apart from each other in the first direction;
forming a plurality of bit-line spacers, each of which contacts both sides of each of the bit-line electrode layers and extends in the second direction; and
forming a plurality of storage-node contact regions, each of which is disposed on the storage-node pad region.
